# EUROPEAN PATENT SPECIFICATION

(11) **EP 3 958 266 B1**
(45) Date of publication and mention of the grant of the patent: **13.08.2025**
(21) Application number: 20305941.5
(22) Date of filing: 21.08.2020
(51) Int. Cl.: G11C 13/00, G11C 11/56, G11C 29/02

(54) **METHOD FOR DETERMINING TARGET RESISTANCE LEVELS FOR A RESISTIVE MEMORY CELL, AND ASSOCIATED MEMORY DEVICE**
VERFAHREN ZUR BESTIMMUNG VON ZIELWIDERSTANDSWERTEN FÜR EINE RESISTIVE SPEICHERZELLE UND ZUGEHÖRIGE SPEICHERVORRICHTUNG
PROCÉDÉ POUR DÉTERMINER DES NIVEAUX DE RÉSISTANCE CIBLES POUR UNE CELLULE DE MÉMOIRE RÉSISTIVE, ET DISPOSITIF DE MÉMOIRE ASSOCIÉ

(43) Date of publication of application: 23.02.2022
(73) Proprietor: Commissariat à l'Energie Atomique et aux Energies Alternatives, 75015 Paris (FR); Weebit Nano Ltd, 4527713 Hod-HaSharon (IL)
(72) Inventor: BRICALLI, Alessandro, 38000 Grenoble (FR); MOLAS, Gabriel, 38054 Grenoble Cedex 09 (FR); PICCOLBONI, Guiseppe, 37124 Verona (IT); REGEV, Amir, Modiin (IL)
(74) Representative: Cabinet Camus Lebkiri

(56) References cited:
- US-A1- 2012 079 353
- US-A1- 2014 068 148
- YOON DOE HYUN ET AL: "Practical nonvolatile multilevel-cell phase change memory", 2013 SC - INTERNATIONAL CONFERENCE FOR HIGH PERFORMANCE COMPUTING, NETWORKING, STORAGE AND ANALYSIS (SC), ACM, 17 November 2013 (2013-11-17), pages 1 - 12, XP032628729, DOI: 10.1145/2503210.2503221

## Description

### TECHNICAL FIELD OF THE INVENTION

The technical field of the invention is, generally, that of microelectronics, more precisely that of non-volatile resistive memories of the filamentary type.

### TECHNOLOGICAL BACKGROUND OF THE INVENTION

New types of non-volatile memories, called resistive memories, or sometimes ReRAM (Resistive Random Access Memory), have been developed over the last few years. These memories can be for example of the filamentary type, such as for OxRAM and CBRAM ("Oxide Random Access Memory" and "Conductive Bridge Random Access Memory"). They can also, in the case of PCRAM (for "Phase change RAM"), be based on a controlled phase change of a material having a resistivity that changes depending on the phase (crystalline or not) of the material.

Anyhow, a resistive memory generally comprises several memory cells, sometimes called "memory points", each storing data represented by a resistance level of the memory cell considered. In general, this data is of the binary type, and the electrical resistance of the memory cell is equal either to a low level or to a high level, depending on whether this data is equal to 0 or 1.

During a write phase, the memory cell can be controlled electrically to bring the electrical resistance to a desired resistance level, which represents the data to be stored. The memory cell then retains (holds) this resistance level, including in the absence of electrical power (as it is a non-volatile memory ; so, the logic information recorded in the memory remains stored in the latter, without being erased, when the memory is powered down).

Progress has been made recently concerning this write phase, and it is now possible to bring the electrical resistance of such a memory cell to a resistance level that is finely controlled, instead of corresponding either to a high level, or to a low level, with no other intermediate level. Thanks to this finer control, it is possible to memorise in the same memory cell data having more than 2 distinct values, which is interesting in terms of information storage density. Such a memory cell is then designated as a "multiple-level" cell.

The following article, for example, shows that a piece of data grouping 2 bits, and which can therefore have 4 different values (values 00, 01, 10 and 11, in binary), can be robustly stored in the same memory cell (here a cell of the OxRam type): "High-Density Multiple Bits-per-Cell 1T4R RRAM Array with Gradual SET/RESET and its Effectiveness for Deep Learning", by E.R. Hsieh et al., IEEE International Electron Devices Meeting (IEDM), 2019, pp 35.6.1 to 35.6.1 (ISBN: 978-1-7281-4032-2).

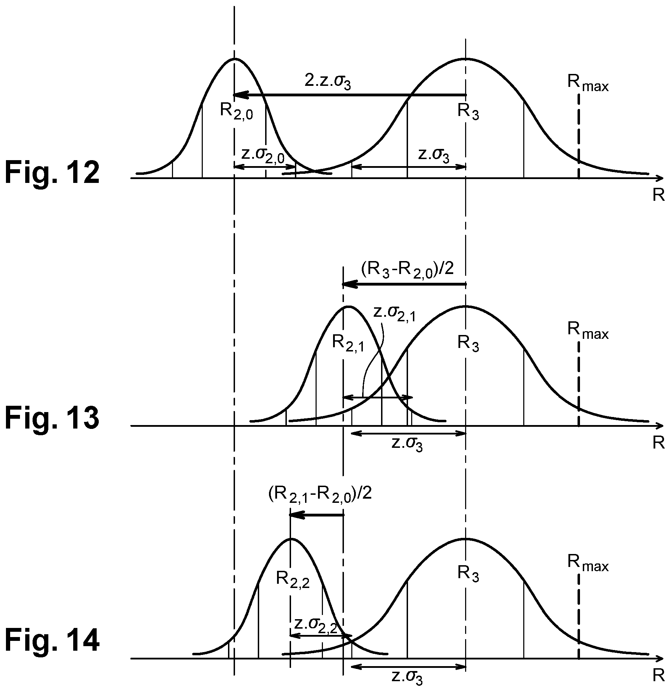

This article also shows that the resistance of the memory cell in question can be adjusted, i.e. controlled, in such a way as to have a value chosen freely from 128 different target resistance levels (see figure 13 of the article in question). In other words, in this memory cell, it would be possible in principle to store a piece of data grouping 7 bits, and that may have 128 different values. But the article in question indicates that, in fact, such a density of information (7 bits per memory cell) should not be implemented in practice for a matrix of memory cells, due to fluctuations from one cell to another.

In this context, it would therefore be beneficial to know how many resistance levels can be implemented in a same resistive memory cell, while keeping a good operating reliability. It would also be beneficial to know how to distribute these resistance levels, within a resistance range that can be accessed by the memory, in such a way as to optimise this operating reliability. The following article describes a method for optimizing the distribution (the positioning) of target resistance levels of a multi-level resistive Phase Change memory cell: "Practical Nonvolatile Multilevel-Cell Phase Change Memory", Doe Hyun Yoon et al., 2013 SC International Conference for High Performance Computing, Networking, Storage and Analysis, ACM, 17 nov. 2013, pp 1-12. Document US 2014/0068148 A1 also describes such a method.

### SUMMARY

For the inventors, the disparity between the different memory cells of a same cells matrix is not the only factor limiting the number of distinct resistance levels that can effectively be used for a robust multi-level storage.

The fluctuations of the resistance of the same memory cell, after this resistance has been adjusted to a given target level, are indeed likely to limit the number of distinct resistance levels that can effectively be used. Indeed, when the number of resistance levels is high (for example equal to 128), the gap between two adjacent levels is very small. The resistance fluctuations, for this memory cell, after writing, can therefore lead to confusion between two adjacent levels (because of this fluctuation, the value obtained at reading can be different from that initially written, and may finally become closer to a - discrete - level different from the level used when writing, thus leading to a storage/reading error).

In addition, during the writing of a memory cell, the target resistance level is rarely reached with absolute precision. In addition to the fluctuations in question (fluctuation after writing), there is therefore a given uncertainty as to the initial value of the resistance of the memory cell, immediately after writing.

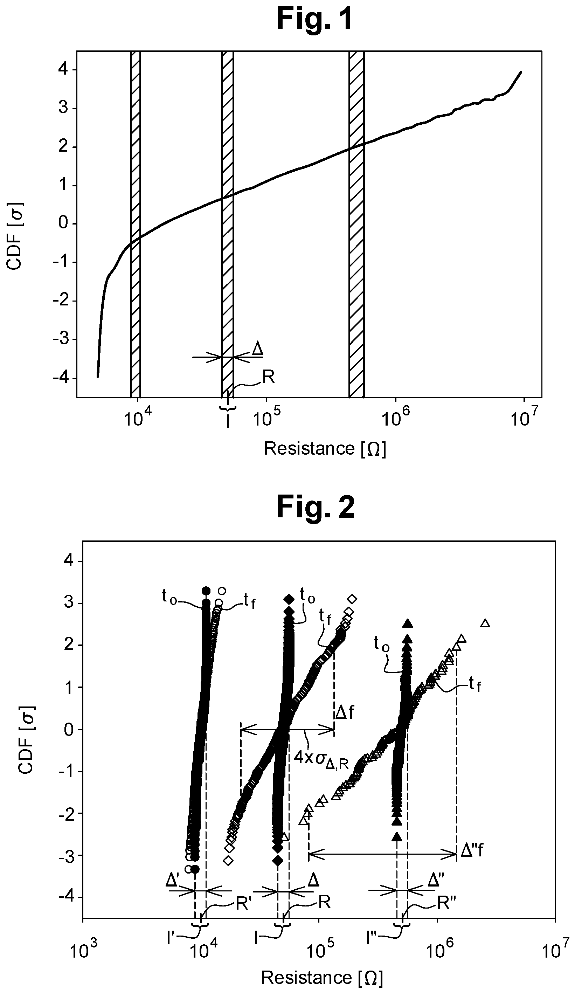

In order to be able to take these two effects into account (initial imprecision of the writing, and later fluctuation), the inventors have measured the change over time of the resistance values of a set of resistive memory cells of the same type, for initial values, after writing, close, but not exactly equal to one another. These initial values can for example be distributed over an interval I whose width Δ is representative at least of the limited precision expected during a write operation (figure 2).

These measurements show that such a distribution of resistance values changes over time by widening, and that the width of this distribution ends up by stabilising. The change in the width of this distribution of resistance values, until the stabilisation thereof, is called relaxing of the memory cell in what follows.

This width after relaxing thus corresponds to a precision that can be expected during the reading of a memory cell, after a substantial storage time. In other terms, it corresponds to the gap that can be expected between, on the one hand, a value that is effectively read after writing and storage (returned value), and, on the other hand, the target resistance level that was targeted during the writing. It therefore provides particularly interesting information concerning a minimum gap to be respected between two adjacent target resistance levels in order to prevent confusion between these levels, during the reading of the memory cell.

The technology presented here is based on these observations. It proposes indeed a method for determining target resistance levels, for a non-volatile resistive memory cell of the filamentary type, having an electrical resistance that can be adjusted to different resistance values, the method comprising a step of determining at least one second target resistance level which is determined based on:
- a first target resistance level, and
- a first resistance dispersion value, representative of the dispersion of a first set of final resistance values obtained, after relaxing of the memory cell, for initial values of the resistance of the memory cell distributed over a first given initialisation interval, having a predetermined width, said dispersion, after relaxing of the memory cell, being the dispersion of said set of resistance values once the quantity σₙ₊₁/σₙ has reached a stable value, at least in average, σₙ and σₙ₊₁ being the standard deviations at an instant tₙ and at a later instant tₙ₊₁ for these initial values of the resistance of the memory cell.

This method may typically be computer-implemented, said step of determining (as well as several possible other steps of the methods) being executed by a computer (this computer comprising at least a processor and a memory device where machine-executable instructions are stored, the execution of these instructions leading to the execution of said method by the computer ; data representative of resistance values after dispersion may also be stored in this the memory device).

The dispersion of the set of resistance values after relaxing mentioned above is typically the highest dispersion expected for this set of resistance values. The second resistance level, and therefore the gap between the first and second resistance levels, are thus determined based on a realistic estimation of the expected uncertainty (i.e.: error) when reading the memory cell. This therefore allows for a more robust operation of a memory device that comprises such memory cells, controlled at target resistance levels determined as indicated above.

The robustness improvement enabled by this technique is substantial, because the widening of a distribution of resistance values, after writing, due to the relaxing of a memory cell, can be particularly high (in particular for high resistance values), often by a factor of 3, or even by a factor of 10 or more.

Moreover, taking account of the dispersion of such a set of resistance values after relaxing, rather than applying an arbitrary multiplicative coefficient (a sort of safety coefficient) to the initial width of this set, for example, allows for an accurate estimation of the expected uncertainty at reading (restitution uncertainty). In other words, in this method, the uncertainty in question is not under-evaluated (since the relaxing is taken into account), nor is it over-evaluated, leading to an optimally utilization of the range of resistances that can be accessed for the memory cell considered (optimal resistance levels density).

Best using the range of resistances that can be accessed, by choosing optimally the gap between two neighbouring target resistance levels, is particularly important in practice. Indeed, it conditions the robustness of the memory but also its total storage capacity which, once determined, is definitively fixed for mass production and later distribution of the electronic component that this memory forms (the term memory means more precisely a memory device comprising several cells or "memory points" of the same type, for example organised in a matrix, as well as an electronic device for controlling the cells).

The first dispersion value in question realistically represents the expected uncertainty at the reading of the memory cell, not only because the distribution of values is considered *after relaxing,* but also because the first initialisation interval has a predetermined non-zero width. Indeed, the measurements mentioned above show that the widening of a distribution of resistance values is all the stronger than the initial width of the distribution is high. Ignoring this initial non-zero width, would therefore lead:
- not only, to ignoring an initial uncertainty linked to the limited writing precision expected in practice,
- but would also lead to underestimating the widening of the distribution of resistance values due to the relaxing (since this widening depends on the initial width of the distribution).

In the method presented above, the width of the first initialisation interval may in particular be at least greater than a control uncertainty, corresponding to a kind of initialisation uncertainty of the memory cell and representative of a precision with which the memory cell can be initialised, i.e. written.

The memory cell may also belong to a memory device that also comprises an electronic control device configured, among other things, to electrically control this memory cell (and, in practice, other memory cells) in such a way as to adjust the resistance of this cell to an initial value that is equal to the first target resistance level, within a control uncertainty. This control uncertainty in particular may be related to the precision and performance of the electronic control device. It can also depend on the more or less elaborate nature of the control sequence used to bring the memory cell to the desired resistance value (sequence that can comprise for example several successive SET and RESET pulses, with an amplitude that varies gradually).

Anyhow, the width of the first initialisation interval, which plays a role in the determination of the second resistance level, may equal to this control uncertainty (initialisation uncertainty of the memory cell).

It can also be greater than this control uncertainty, to further take account of the limited precision with which the memory cell will be finally read. The reading precision is indeed limited also, in practice, for example by disturbance signals and other electronic noise that impairs the electrical signals used during the read operation. In general, the reading precision is all the less good than the resistance value to be read is high (because, during the reading, the electric current that passes through the resistance, and which allows for determining the value thereof, is low, and is therefore more easily disturbed and more difficult to measure).

The width of the first initialisation interval may in particular be all the higher than the first target resistance level is high. The fact that the control precision mentioned hereinabove (initial write precision), as well as the read precision are generally all the less good than the resistance is high are thus taken into account.

The width of the first initialisation interval may also be at least greater than a minimum initial width, in order to prevent having to implement excessively complex write sequences. For such a memory cell, of the filamentary type, for example an OxRAM cell, this minimum initial width can for example be chosen equal to 1, 2 or 4 kiloOhms.

Note that, throughout this document, the term "dispersion" designates any quantity representative of the width of a distribution of values. This can thus be, for example, the standard deviation of this distribution (i.e. the square root of the mean square of this distribution), the double of this standard deviation, the 4-th order moment of this distribution to the power of 1/4, an average of the absolute values of the deviations, or any other quantity representative of the width in question.

The measurements made by the inventors show moreover that the widening due to the relaxing depends not only on the initial width of the distribution considered, but also on the mean value on which this distribution is centred. Here, this widening (i.e. this increase in width) is all the stronger than the initial resistance values are high (see figure 2). In the case of OxRAMs for example, the fact that the fluctuations and the widening by relaxing are higher for high resistance values (i.e. for the thinnest conducting filaments) is intrinsically linked to the physical phenomena at play in the memory cell.

Anyhow, it is desirable that the first target resistance level be comprised in the first initialisation interval, so that the first dispersion value is as representative as possible of the global uncertainty finally expected when reading the memory cell after it had been written at the first target resistance level.

So, in the method for determining presented hereinabove, the first initialisation interval in question may in particular include the first target resistance level.

According to an optional characteristic of the method of determining, the second resistance level is determined, during said step of determining, based furthermore on a second resistance dispersion value, representative of the dispersion of a second set of final resistance values obtained, after relaxing of the memory cell, for initial values of the resistance of the memory cell distributed over a second given initialisation interval that includes the second target resistance level.

The second initialisation interval can have the same properties as the first initialisation interval. In particular, it can have a width:
- greater than or equal to the control uncertainty mentioned above (uncertainty of the initial adjustment of the resistance), and/or
- greater than or equal to the minimum initial width mentioned above (minimum threshold), and/or
- all the higher than the second target resistance level is high.

The second target resistance level can in particular be determined, during said step of determining, in such a way that a gap between the first and the second target resistance levels is greater than or equal to a sum of the first and second dispersion values, multiplied by a given spacing coefficient.

The spacing coefficient in question can for example be equal to 1 (in which case the gap between the first and the second resistance levels is greater than or equal to the sum of the first and second dispersion values).

More generally, the spacing coefficient can be chosen according to a tolerated probability of error, at most, during the restitution of data stored in the memory cell. The value of the spacing coefficient is then chosen so as to be all the higher than the probability of error, tolerated during the restitution, is low.

By way of example, when the first and second dispersion values are the standard deviations, respectively of the first and of the second sets of final resistance values, the spacing coefficient in question can be equal to 2 if, at most, a probability of error at restitution of about 5% is tolerated. A restitution error corresponds to a situation wherein the data returned, deduced from the resistance value read, is different from the data initially provided, to be memorised (which occurs in particular if the resistance value read, after storage, is closer to another target resistance level than the one targeted during the writing). And if the maximum tolerated probability of error at restitution is less than 5% (for example equal to 2%), a value greater than 2 will be chosen for the spacing coefficient in question.

According to an optional feature of said method, the second target resistance level is determined by successive iterations, during said step of determining, and, at each iteration:
- if the gap between the first target resistance level and the second target resistance level is smaller than the sum of the first and second dispersion values multiplied by said spacing coefficient, the second initialisation interval to which the second dispersion value corresponds being centred on the value considered for the second target resistance level during said iteration,
- then, at a next iteration, the gap between the first target resistance level and the second target resistance is increased,
- said gap being otherwise reduced, at the next iteration.

In particular, these successive iterations may be carried on according to a bisection method.

Moreover, during the method in question, several target resistance levels may be determined, and, except for one of said resistance levels, having a maximum or a minimum value, each one of said resistance levels may be determined by executing said step of determining, the target resistance level considered being determined as being equal to said second resistance level, and, each time that the step of determining is executed again, the first target resistance level is taken as equal to the second target resistance level determined during a previous execution of the step of determining, for example during the immediately preceding execution of the step of determining.

It can also be provided more generally, during this method, to determine a set of target resistance levels in such a way that, for each pair comprising any two of said resistance levels, a gap between the two resistance levels of the pair considered is greater than or equal to:
- the sum:
   - of a first resistance dispersion value, representative of the dispersion of a first set of final resistance values obtained, after relaxing of the memory cell, for initial values of said resistance distributed over a first initialisation interval including a first of the two target resistance levels of the pair considered, and
   - of a second resistance dispersion value, representative of the dispersion of a second set of final resistance values obtained, after relaxing of the memory cell, for initial values of said resistance distributed over a second initialisation interval including the second of the two target resistance levels of the pair considered,
- multiplied by said spacing coefficient.

The method in question can comprise a step of determining a storage capacity of the memory cell, during which a maximum number of target resistance levels that can be contained within a given range of resistances extending from a minimum resistance value to a maximum resistance value is determined, said resistance levels being determined such as explained above, said spacing coefficient remaining fixed, equal to a given minimum spacing coefficient.

Thus, during this step of determining the storage capacity of the memory cell, it is not sought to optimise, i.e. maximise the gap between adjacent levels. In terms of gap, it is sought only that the gap between two adjacent levels be at least equal to the sum of the first and second dispersion values, multiplied by the minimum spacing coefficient. The value of the minimum spacing coefficient is for example determined as explained hereinabove.

During this step, not only can the maximum number of target resistance levels in question be determined, but also the values of these resistance levels.

The method for determining can also comprise a step of distributing target resistance levels, during which:
- the total number of target resistance levels considered remains constant, and
- said target resistance levels are determined: as explained above (in such a way as to respect a minimum gap between adjacent levels), in such a way as to remain within the range of resistances in question, and furthermore, in such a way as to maximise said spacing coefficient.

This step of distributing is so to speak a step of optimising the distribution (the spreading) of the resistance levels, within the range of resistances in question, for a fixed number of levels.

During this method, it is possible for example to execute first the step of determining the storage capacity of the memory cell, and then to execute the step of distributing target resistance levels, the total number of target resistance levels considered during the of distributing being equal to the maximum number of target resistance levels acceptable, determined during the step of determining the storage capacity of the memory cell.

The method can moreover comprise a preliminary step of characterising the memory cell, comprising the following steps:
- measuring final resistance values after a certain duration of storage, for several different initial resistance values, and
- determining at least the first dispersion value, from the final resistance values thus measured.

In practice, all of the dispersion values required to determine the target resistance levels can be determined in this way, based on these measurements of final resistance values. These final values can in particular be the final values, after relaxing of the memory cell. The series of measurements in question could be achieved by initialising the memory cell to a first initial value, then by measuring the corresponding final value. And then by initialising the memory cell to a second, different initial value, and by measuring the corresponding final value. But, in practice, it is clearly faster to initialise a whole set of memory cells of the same type, to different initial values, then to measure the final resistance values for all these different cells.

The memory cell, for which target resistance levels are determined thanks to the method in question, can be a multi-level memory cell, suitable for being adjusted, during a write phase, to at least three separate and stable resistance values, i.e. retained at least partially, with no confusion between them, after writing.

This memory cell is of the filamentary type, i.e. a memory cell comprising an electrically-conductive filament passing through a layer which, outside the filament, is globally insulating from an electrical point of view. The filament in question has an electrical resistance that can be adjusted, by a suitable electrical control of the cell. The filament can in particular be broken, then reformed, then partially broken, and so on during successive write cycles.

The different optional characteristics presented above can be combined together according to any technically permissible combination.

The present technology is also related to a memory device comprising several non-volatile resistive memory cells of the filamentary type, and an electronic control device for controlling the memory cells, the electronic control device being configured to, during the writing of a piece of data in one of said memory cells, electrically control said memory cell in such a way as to bring a resistance of the memory cell to a target resistance level belonging to a discrete and predetermined set of target resistance levels, said target resistance levels, that the electronic control device is configured to write in the memory cells, being separated two by two by a gap that is at least greater than the sum:
- of a first resistance dispersion value, representative of the dispersion of a first set of final resistance values obtained, after relaxing of the memory cell, for initial values of said resistance distributed over a first initialisation interval having a predetermined width and including a first of the two target resistance levels considered, said dispersion, after relaxing of the memory cell, being the dispersion of said set of resistance values once the quantity σₙ₊₁/σₙ has reached a stable value, at least in average, σₙ and σₙ₊₁ being the standard deviations at an instant tₙ and at a later instant tₙ₊₁ for these initial values of the resistance of the of the memory cell, and
- of a second resistance dispersion value, representative of the dispersion of a second set of final resistance values obtained, after relaxing of the memory cell, for initial values of said resistance distributed over a second initialisation interval also having a predetermined width and including the second of the two target resistance levels considered.

The target resistance levels, that the electronic control device is configured to write in the memory cells, are for example determined, in a first step (before being implemented in the electronic control device), in accordance with the method of determining described hereinabove, on the basis of characterisation measurements taken beforehand on the memory cells of this memory device, or of a memory device of the same type (having the same characteristics).

The electronic control device can be implemented in the form of an electrical circuit comprising one or several sources of current or voltage electrically controlled. This electrical circuit can be configured, or even reconfigured electrically. It comprises for example a processor associated with a memory, or any another programmable circuit, programmed to control the writing of the memory cells at the target resistance levels in question. This device can also comprise a system for addressing memory cells.

Only embodiments comprising all the features of one of the independent claims 1, 14 fall under the scope of protection of the present invention.

The present technology and its different applications shall be better understood when reading the following description and in examining the accompanying figures.

### BRIEF DESCRIPTION OF THE FIGURES

The figures are presented for the purposes of information and in no way limit the invention.
[Fig. 1] Figure 1 schematically shows the cumulative distribution function of a set of initial resistance values, for different memory cells of a resistive memory device that have been adjusted to different initial values.
[Fig. 2] Figure 2 schematically shows cumulative distribution functions, before and after relaxing, for three different sets of initial resistance values.
[Fig. 3] Figure 3 shows the evolution of the width of a distribution of resistance values over time, during the relaxing of a resistive memory cell.
[Fig. 4] Figure 4 shows three target resistance levels for a resistive memory cell, determined using a method based on the technology presented hereinabove
[Fig. 5] Figure 5 shows different steps of the method in question, as a flow chart.
[Fig. 6] Figure 6 schematically shows how a second target resistance level is determined, depending on a first target resistance level, in the method of figure 5.
[Fig. 7] Figure 7 schematically shows target resistance levels determined, iteratively, during a first phase of the method of figure 5.
[Fig. 8] Figure 8 schematically shows target resistance levels determined, iteratively, during a second phase, of optimisation, of the method of figure 5.
[Fig. 9] Figure 9 shows another example of target resistance levels for a resistive memory cell, determined by a method such as the one of figure 5.
[Fig. 10] Figure 10 shows another embodiment of a method for determining target resistance levels for a resistive memory cell.
[Fig. 11] Figure 11 schematically shows a re-writable non-volatile memory device, comprising several resistive memory cells.
[Fig. 12] Figure 12 schematically shows an initial estimation of a target resistance level, determined, during the method of figure 5, according to a bisection, iterative method.
[Fig. 13] Figure 13 schematically shows a first estimation of this target resistance level, determined according to this bisection method.
[Fig. 14] Figure 14 schematically shows a second estimation of this target resistance level, determined according to this bisection method.

### DETAILED DESCRIPTION

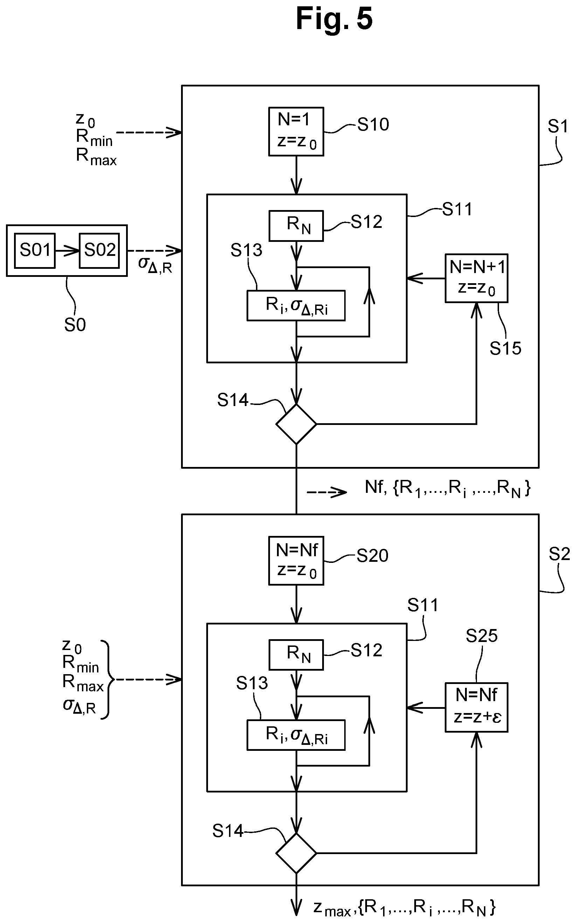

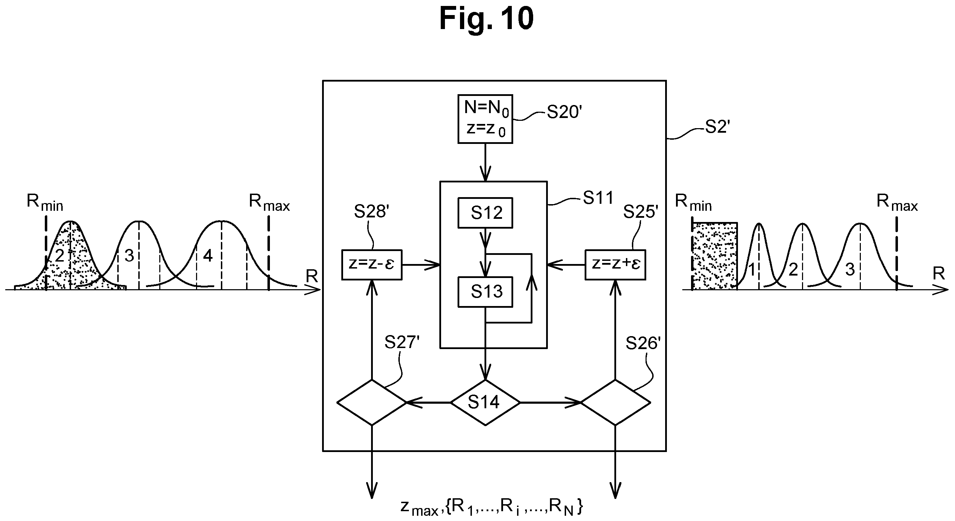

As indicated above, the technology presented here relates, in particular, to a method for determining target resistance levels for a non-volatile resistive memory cell. A first and a second embodiment of this method are shown schematically, respectively in figure 5 and in figure 10.

The memory cell in question is a filamentary memory cell, such as one of the OxRAM type, or of the CBRAM type.

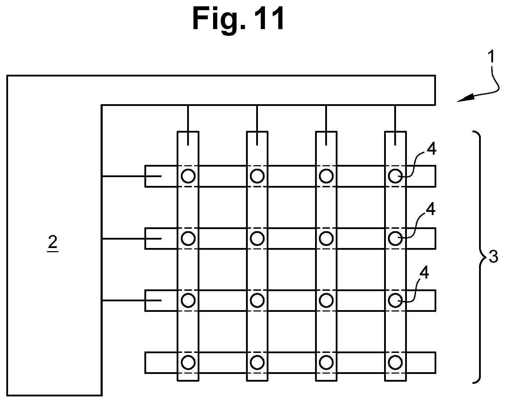

In practice, the memory cell 4 is part of a memory device 1 comprising:
- a matrix 3 of memory cells 4 of the same type, that can be addressed individually, and
- an electronic device 2 for controlling memory cells that makes it possible to write and to read the memory cells (figure 11).

Once this memory device 1 is in the usage phase (after manufacturing and configuration of this device), to write a piece of data in one of the memory cells 4, the electronic control device 2 controls the memory cell in question in such a way as to adjust the resistance thereof to one of the target resistance levels mentioned, which have been determined beforehand (before the final configuration of the memory 1), thanks to this method of determining. The target resistance levels mentioned above thus form the discrete set of resistance values that the electronic control device 2 is configured to write in the memory cells 4.

During the method for determining, these target resistance levels are determined in such a way that they are sufficiently separated from one another, in order to prevent confusion between levels during the reading of the memory cell 4. In other words, the objective is to prevent the value of the resistance of the memory cell 4, returned after a certain storage time, from being closer to a resistance level different from the one at which it was initially adjusted, during the writing.

**In** order to prevent confusion between levels, during the reading of the memory cell 4, the target resistance levels are determined taking into account the fluctuations that the resistance of this cell can have, after writing. To take these fluctuations into account, the basis used is the dispersion, after relaxing, of a set of resistance values that, initially, were located in a narrow interval (initialisation interval) surrounding the resistance level considered.

For the embodiments described in reference to the figures, this dispersion is the standard deviation σ of this set of final resistance values. Alternatively, it could however be another quantity representative of the width of such a distribution of values.

In what follows, the dispersion of a set of final resistance values obtained, after relaxing of the memory cell, for initial values of this resistance distributed over a given initialisation interval I, is noted as σ_{Δ,R}, where Δ is the width of this interval and where R is the mean value on which this interval is centred.

First of all, in reference to figures 1 to 3, the way of determining the dispersion values σ_{Δ,R} will be described, for different average resistance values R distributed over the entire range of resistance [Rₘᵢₙ, Rₘₐₓ], that can be accessed by the memory cell.

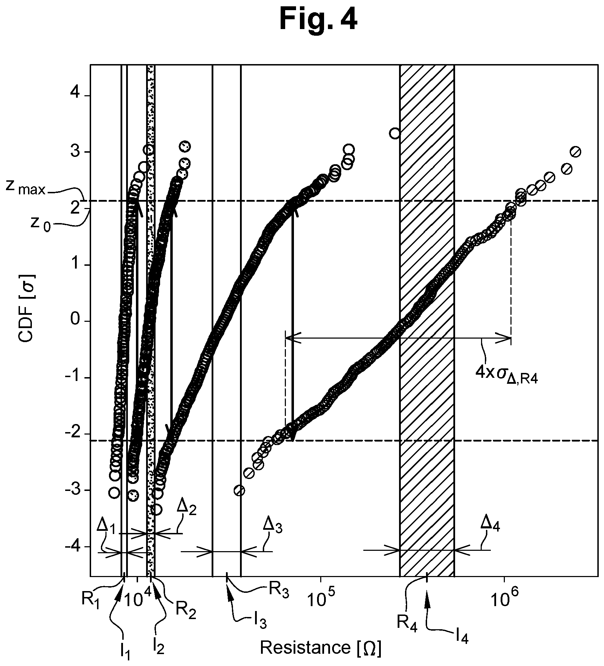

Then, in reference to figures 4 to 9, the way to determine the target resistance levels R1, ... Ri, ...R_{N}, based on these dispersion values σ_{Δ,R}, will be described.

Figure 1 shows a cumulative distribution function of initial resistance values, for all of the resistive memory cells 4 that belong to the matrix 3 of memory cells of figure 11. These memory cells are of the same type, and have the same structure (same dimensions, same materials forming the cell, cells manufactured at the same time during the manufacturing of the matrix in question). Here, these are memory cells of the OxRAM type. The ordinate axis corresponds to the value of the distribution function, or CDF (Cumulative Distribution Function), and the abscissa axis corresponds to the associated resistance value, expressed in Ohms. This cumulative distribution function is obtained by measuring the resistance values of these different memory cells (i.e. by "reading" these memory cells), immediately after their writing, the respective resistances of these different cells having been adjusted initially to different values, distributed over the entire range of resistance values that can be considered for the operation of these memory cells. Here, the cumulative distribution function of figure 1 is obtained from measurements taken on a matrix comprising about 16,000 separate memory cells.

During this series of measurements, the respective resistance values of these different cells were measured, not only immediately after their writing, but also after a given storage time, in order to characterise their subsequent variations. Here, for example the values of these different resistances were measured at a regular interval (every 2 minutes) for several hours. This way of proceeding makes it possible, in a single series of measurements, to characterise the change in the resistance of a memory cell 4 of this type, after writing, for the entire range of resistance values considered (this allows for substantial time to be saved, compared to a characterisation carried out on a single cell).

To determine the dispersion after relaxing σ_{Δ,R}, associated with a given interval I of initial resistance values, centred on an average value R, and of width Δ, it is possible for example to select, from the different memory cells of this matrix, those that, immediately after writing, have a resistance value comprised in the interval I in question (see figure 1). Figure 2 shows the cumulative distribution function of such a set of initial resistance values (immediately after writing, at an initial instant to). The dispersion σ_{Δ,R} is then calculated from the resistance values of this same group of memory cells, after relaxing. The resistance values of the group of memory cells thus selected can be monitored over time in a practical manner, since each memory cell is marked (and can be addressed) individually, in the matrix 3 in question. Figure 2 shows the cumulative distribution function of the resistance values of this group of memory cells, after relaxing, at a subsequent instant t_{f}, well after the writing (here 5 hours after the writing of these cells). In other words, this cumulative distribution function is that of a set of final resistance values, obtained after relaxing, for initial values distributed over the interval I, of width Δ.

As can be seen in figure 2, for such memory cells, the width of such a distribution of resistance values increases substantially over time (before stabilising), during the relaxing of the memory cells. For this example, the width Δf at the instant t_{f} is about 10 times greater than the initial width Δ, just after writing. Indeed, the width Δf is about 100 kiloohms, while the initial width Δ is about 10 kiloohms. The term "width" can, as here, designate 4 times the standard deviation of the set of values considered (or Δf = 4σ_{Δ,R}, and Δ = 4σ, σ being the standard deviation of the set of initial values considered).

Figures 1 and 2 show, for the purposes of illustration, two other intervals of initial resistance values, I' and I", centred on other average resistance values (R' and R"). The interval I' is centred on a value R' of about 10 kiloohms and has a width Δ' of about 2 kiloohms. Regarding the interval I", it is centred on value R", of about 500 kiloohms, and has a width Δ" of about 100 kiloohms. The cumulative distribution function obtained at the initial instant to, and at the instant t_{f}, for a group of memory cells that has initial resistance values spread over the interval I', is shown in figure 2, and the same applies for the interval I". As can be observed in this figure, the widening due to the relaxing is all the higher than the average resistance considered is high (the final width Δf", of about 1 Megohm, is clearly greater than the final width Δf).

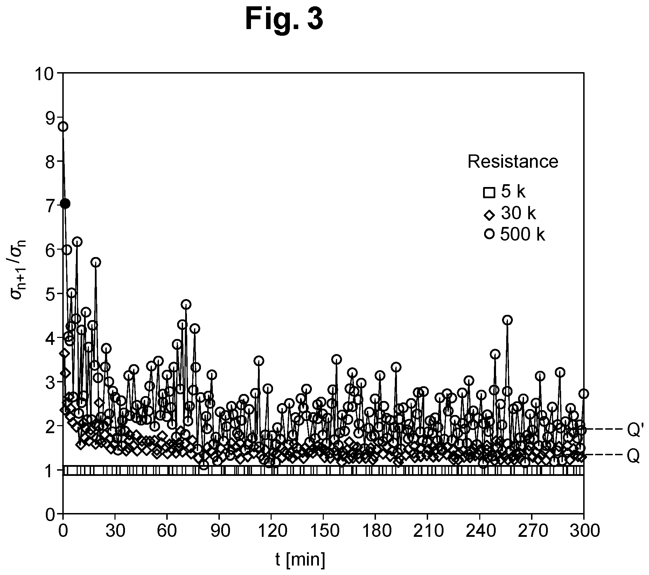

Figure 3 shows the change, over time t (expressed in minutes), of the quantity σₙ₊₁/σₙ where σₙ is the standard deviation at an instant tₙ of the resistance values of a set of memory cells initially having close resistance values, for example contained in the interval I, I' or I" mentioned above. σₙ₊₁ is the standard deviation of the resistance values of this same set of memory cells, at a later instant tₙ₊₁, typically a few minutes after the instant tₙ. Three series of measurements are shown in figure 3, for three different groups of memory cells, corresponding to three intervals of initial resistance values centred respectively on average resistances of 5, 30 and 500 kiloohms.

For the intervals initially centred on 30 and 500 kiloohms, the quantity σₙ₊₁/σₙ varies significantly (decreases significantly) immediately after the initialisation of the memory cells (i.e. immediately after the writing of these cells, at the instant to=0), then it finishes by stabilising at a constant value, Q, or Q'. Here, this stabilisation occurs after about half an hour. It is this initial variation phase (which lasts here about half an hour) that corresponds to the relaxing of the memory cells. At the end of this phase, a set of initial resistance values, initially rather narrow, has been redistributed to reach a stable, wider distribution (at least stable in average, i.e. averaged over a few successive readings of the group of memory cells). The expression "dispersion of final resistance values *after relaxing"* may, like here, designate the dispersion of such a distribution of values after this initial variation phase (i.e. once the quantity σₙ₊₁/σₙ has reached a stable value, at least in average), that is to say the dispersion after *full* relaxing. Alternatively, the expression "dispersion of final resistance values *after relaxing"* could designate the dispersion of such a distribution of values after a partial relaxing only, that is to say after a given time not necessarily as long as the full relaxing time mentioned above (indeed, even if the relaxing is not completely achieved, taking into account a dispersion *some time after the initial writing,* instead of just considering the width Δ immediately after writing, enables to obtain more robust target resistance levels) ; this given time may for instance be a fixed time higher than 15 minutes, for instance between 15 minutes and 5 hours. Anyhow, as already indicated, here, a full relaxing requires approximately half an hour, here. So, there is no doubt that the width Δf, or Δf" mentioned above (see figure 2), which is obtained 5 hours after the writing, is indeed the width after full relaxing, for the initialisation interval I, I" considered.

As explained above; monitoring over time the resistance values of different memory cells of the same matrix of memory cells, initially set to different values (during the writing), allows for determining dispersion values σ_{Δ,R}, after relaxing, for different intervals of initial values, these intervals being distributed over the entire range of resistance values considered for the operation of these memory cells.

This range of values corresponds here to the entire range of values that are accessible for this type of cell memory, i.e. to all the values to which the memory cell resistance can be adjusted, during a write phase. This range extends from a minimum value Rₘᵢₙ to a maximum value Rₘₐₓ. For a memory cell of the OxRAM type, for example, the minimum value Rₘᵢₙ is comprised typically between 1 and 5 kiloohms, while the maximum value is generally greater than 1 megohm, for example comprised between 1 and 2 megohms.

As mentioned above, the dispersion value after relaxing, σ_{Δ,R}, associated with a given interval of initial values, depends on the average value R on which this interval is centred (it is in general all the higher than this average value R is high). And this dispersion value σ_{Δ,R} also depends on the width Δ of the interval of initial values considered.

Here, the dispersion values σ_{Δ,R}, after relaxing, are thus determined for intervals of initial values having widths Δ representative (among others) of an expected precision during the writing of a memory cell of this matrix.

Indeed, the dispersion value σ_{Δ,R} then provides information on the uncertainty expected during the reading of this memory cell, in view of both the limited precision of the writing operation, and the relaxation effect. In other words, this dispersion value σ_{Δ,R} is then representative of the width of the interval wherein it is probable (with a high probability, for example greater than 95%) that the value, returned finally by the memory cell during the reading, is included (when this cell was initially written at the target value R, or, more precisely, when it is written by targeting the target write value R, for example with a writing precision of plus or minus Δ/2).

Here, the method thus comprises the following steps:
- S01: taking the series of measurements presented above (following over time the respective resistance values of several memory cells of the same type, belonging to the same matrix, these cells having been written at initially different values distributed between Rₘᵢₙ and Rₘₐₓ), then,
- S02: based on these measurements, determining dispersion values σ_{Δ,R}, after relaxing,
   - for different intervals of initial values which each have a width Δ representative, among others, of an expected precision during the writing of such a memory cell,
   - the intervals of initial values in question being distributed over the entire range ranging from Rₘᵢₙ to Rₘₐₓ.

**In** the method for determining target levels shown in figure 5, the two steps S01 and S02 are carried out during a preliminary step of characterisation S0. The target resistance levels themselves are then determined, during steps S1 and S2, based on these dispersion values after relaxing σ_{Δ,R}.

### Step S0.

The widths Δ of the intervals of initial values, used during the step S0, to determine the dispersions after relaxing σ_{Δ,R}, are therefore chosen in such a way as to be representative at least of the limited precision expected during the writing of such memory cells.

This writing precision (or, in other terms, this initialisation precision) depends in particular on the performance of the electronic control device 2 (electronic noise impairing the electrical control signals delivered by this device, more or less elaborate control sequence used during the writing). This writing precision is characterised by a control uncertainty, i.e. by a mean difference between a resistance value, aimed at during the writing (target value), and the value effectively reached by the resistance of the memory cell after the write phase. This control uncertainty, also called initialisation uncertainty, may for instance be determined by achieving a series of measurement of this mean difference.

**In** order to take this limited writing precision into account, the widths Δ of the intervals of initial values can be chosen equal to the initialisation uncertainty in question. These widths Δ can also be chosen greater than the initialisation uncertainty, in order to also take account of the limited precision with which the memory cell will finally be read.

Moreover, it is desirable that the widths Δ of the intervals of initial values, taken into account in step S0, be all the higher than the corresponding average resistances R are high. Indeed, the writing precision, and the reading precision, are generally all the lower than the resistance R is high. For a memory cell of the OxRAM type, one may choose, by way of example, widths Δ of 3, 10 and, respectively, 250 kiloohms, for average resistances R of 10, 25 and 400 kiloohms.

As already mentioned, the widths Δ can be determined based on measurements of initialisation uncertainties (writing uncertainties). But they can also be determined based on relaxing measurements themselves (measurements of fluctuations after writing), in the following way. A very narrow interval centred on the average value R considered is first of all selected. This interval can for example have a width equal to 5% of the average value R. The dispersion value after relaxing σ is then determined for this very narrow interval, then this dispersion value is multiplied by a constant coefficient δ, for example equal to 3, in order to finally obtain a value of width Δ. This method of proceeding, which could seem arbitrary at first sight, leads in fact to widths Δ(R) that are well-suited for determining finally the dispersion values after relaxing σ_{Δ,R} (these widths are noted as Δ(R), here, since they generally depend on the average resistance R). Indeed, the widths Δ(R) thus determined are, intrinsically, all the higher than the associated average resistance R is high (since these widths are based on the relaxing after writing). And it turns out that the widths thus determined are representative of the initialisation uncertainties expected in practice.

Anyhow, during the execution of the step S02, the widths Δ are input data, known, on the basis of which the dispersions after relaxing σ_{Δ,R} are determined. At the end of the step S0, several pairs of values (R, σ_{Δ,R}) that each include
- a resistance value R,
- as well as a dispersion value after relaxing σ_{Δ,R} associated with an interval of initial values centred on R and of width Δ(R),
have been determined, the resistance values R being distributed over the entire resistance range [Rₘᵢₙ, Rₘₐₓ].

Once the dispersion values after relaxing σ_{Δ,R} have been determined (in step S0), a set of target resistance levels R₁, ... Rᵢ, ...R_{N} included in the resistance range [Rₘᵢₙ, Rₘₐₓ] is determined. This set of target resistance levels will form the discrete set of fixed resistance values, to be written in the memory cells 4 of the device, during the operation of the memory device 1 (once que memory device is in operation, after the manufacturing and configuration phase).

As shown in figure 4, the target resistance levels in question, R₁, ... Rᵢ, ... , R_{N}, are determined in such a way that, for each pair comprising two neighbouring target resistance levels, Rᵢ and Rᵢ₊₁ (for example levels R₃ and R₄, in figure 4), the two resistance levels Rᵢ and Rᵢ₊₁ are separated by a gap that is greater than or equal to:
- the sum:
   - of a first dispersion value after relaxing, σ_{Δ,Ri}, corresponding to an interval Iᵢ of initial resistance values comprising a first of these two resistance levels, Rᵢ (the interval having a width Δ(Rᵢ)), and
   - of a second dispersion value after relaxing, σ_{Δ,Ri+1}, corresponding to an interval Iᵢ₊₁ of initial resistance values comprising the second of these two resistance levels, Rᵢ₊₁ (the interval having a width Δ(Rᵢ₊₁)),
- multiplied by a minimum spacing coefficient zₒ, equal to 2, here.

The gap Rᵢ₊₁ - Rᵢ between these two adjacent target resistance levels is therefore greater than or equal to 2(σ_{Δ,Ri} + σ_{Δ,Ri+1}), here. The same applies for each pair of adjacent resistance levels.

In the example of figure 4, the memory cell 4 considered is a multi-level memory cell (here of the OxRAM type) in which it possible to robustly memorise a piece of data grouping 2 bits. Indeed, four target resistance levels R₁, R₂, R₃ and R₄, spaced from one another as explained above (i.e. with a gap greater than or equal to 2(σ_{Δ,Ri} + σ_{Δ,Ri+1}) between adjacent levels), can be placed in the range of resistances [Rₘᵢₙ, Rₘₐₓ]. The target resistance levels R₁, R₂, R₃ and R₄ represented in figure 4 have been determined using the method for determining of figure 5.

Figure 4 also shows the initialisation intervals, of respective widths Δ₁, Δ₂, Δ₃ and Δ₄, associated with the target resistance levels R₁, R₂, R₃ and R₄. These initialisation intervals each include the resistance level in question R₁, R₂, R₃ or R₄. These are intervals of widths Δ(R₁), Δ(R₂), Δ(R₃) and Δ(R₄) (the quantity Δ(R) was defined hereinabove). These initialisation intervals I₁, I₂, I₃ and I₄ are some kinds of programming intervals, aimed at during the writing of the memory cell 4, (once the memory device 1 is in operation). By way of example, when the value of the piece of data to be memorised (for example the binary value 01) is represented by the third target resistance value R₃, then, during the writing of this data in the memory cell 4, the electronic control device 2 controls the memory cell 4 by aiming at the programming interval I₃ (of width Δ₃), so as to bring the resistance of the memory cell in this interval. For the example of figure 4, the initialisation intervals I₁, I₂, I₃ and I₄ extend respectively from 8 to 9 kiloohms for I₁, from 11 to 12.5 kiloohms for I₂, from 25 to 37 kiloohms for I₃ and from 270 to 550 kiloohms for I₄.

Figure 4 also shows the distribution functions CDF of the final values obtained, after relaxing, for sets of initial values distributed respectively over the initialisation intervals I₁, I₂, I₃ and I₄.

Figure 5 shows the first embodiment of the method for determining target resistance levels, as a flow chart.

In this method, the preliminary step of characterising S0 that was described above is first executed.

The method then comprises a step of determining a storage capacity of the memory, S1. During this step, one determines a maximum number Nf of target resistance levels, that can contained within the range of resistances [Rₘᵢₙ, Rₘₐₓ] while still maintaining a gap of at least zₒ×(σ_{Δ,Ri} + σ_{Δ,Ri+1}) between two neighbouring target resistance levels Rᵢ and Rᵢ₊₁, zₒ being the minimum spacing coefficient mentioned above.

The value of the minimum spacing coefficient zₒ can be chosen, as explained above in the part entitled "summary", as a function of a probability of error tolerated at most for the restitution of data stored in the memory cell. Here, for example, the minimum spacing coefficient zₒ is taken equal to 2, so that a probability of error, at restitution, is less than about 5%.

Here, during step S1, the target resistance levels are determined more precisely in such a way as to be as numerous as possible, while maintaining a gap equal to zₒ×(σ_{Δ,Ri} + σ_{Δ,Ri+1}) between two adjacent levels (or, optionally, slightly higher than this quantity). In other words, during this step, the number of target resistance levels is maximised without seeking to maximise the gap between target levels (the spacing coefficient being just maintained at the minimum value zo, considered as acceptable in terms of robustness).

Moreover, during step S1, the target resistance levels are determined in such a way that the highest target resistance level, R_{N}, is separated from the highest resistance accessible for the memory cell, Rₘₐₓ, by at least zₒ×σ_{Δ,RN}. Thanks to this, even when the memory cell is initialised by targeting the highest target resistance level R_{N}, the resistance value *obtained after relaxing* remains (with a high probability) within the range [Rₘᵢₙ, Rₘₐₓ].

Likewise, during step S1, the target resistance levels are determined in such a way that the lowest target resistance level, R₁, is separated from the lowest resistance accessible for the memory cell, Rₘᵢₙ, by at least z_{o×}σ_{Δ,R1}.

The method then comprises a step of distributing target resistance levels, S2, during which the total number of target resistance levels considered, N, remains constant, here equal to the maximum number Nf previously determined in step S1, while the gap between target resistance levels is maximised.

More precisely, during step S2, the target resistance levels are determined so that a gap Rᵢ₊₁ - Rᵢ between two adjacent levels is equal to z×(σ_{Δ,Ri} + σ_{Δ,Ri+1}) (or at most slightly greater than this quantity), and in such a way as to maximise the spacing coefficient z (while maintaining the set of N target resistance levels within the range [Rₘᵢₙ, Rₘₐₓ]).

Moreover, as for step S1, the target resistance levels are determined, during step S2:
- in such a way that the highest target resistance level, R_{N}, is separated from the maximum resistance Rₘₐₓ by at least zₒ×σ_{Δ,RN} and
- in such a way that the lowest target resistance level, R₁, is separated from the minimum resistance Rₘᵢₙ by at least zₒ×σ_{Δ,R1}.

The steps S1 and S2 are now described in more detail.

### Step S1

Step S1 comprises a step of initialising S10 during which:
- the number N of target resistance levels to be determined is set to an initial value, here equal to 1, and
- the spacing coefficient z is set to an initial value, here equal to zₒ.

A step S11 of determining a set of N target resistance levels R1, ... Ri, ..., R_{N} is then executed. During this step, the target resistance levels are determined in such a way that the gap between two neighbouring levels is equal to zₒ×(σ_{Δ,Ri} + σ_{Δ,Ri+1}) (or, possibly, slightly greater than this quantity, due to approximations in the estimation of the dispersions), and in such a way that the highest target resistance level, R_{N}, is separated from the maximum resistance Rₘₐₓ by at least zₒ×σ_{Δ,RN}.

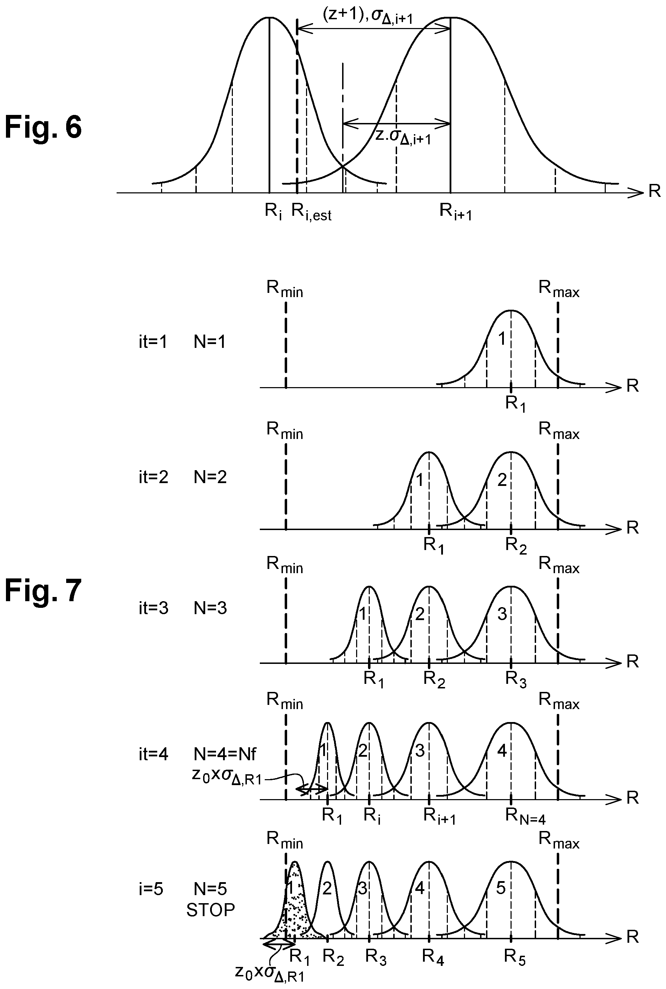

The step S11 is repeated, by increasing by 1 the value of N at each new execution, until the lowest target resistance level, R1, becomes too close to the minimum resistance Rₘᵢₙ (see figure 7). In other words, step S11 is iterated, by incrementing N by 1 at each iteration, until the gap R1 - Rₘᵢₙ is less than zₒ×σ_{Δ,R1}.

When the target resistance levels R1, ... Ri, ..., R_{N}, obtained by executing step S11, are such that R1 - Rₘᵢₙ < zₒ×σ_{Δ,R1}, the repetitions of step S11 stop and step S1 ends. The target resistance levels finally adopted at the end of step S1 are those determined during the second last iteration of the step S11, i.e. during the iteration that immediately precedes the iteration for which the resistance level R1 is too close to the minimum resistance Rₘᵢₙ. The maximum number Nf of target resistance levels, finally determined during step S1, is equal to the value of the number N during the second last iteration of the step S11.

Step S11 is now described in more detail.

This step first comprises a step S12, during which the highest target resistance level, R_{N}, is determined.

During step S12, the objective is to determine the resistance level R_{N} in such a way that the gap Rₘₐₓ - R_{N} is greater than or equal to zₒ×σ_{Δ,RN}. But as R_{N} is not known, at the beginning of the step S12, the corresponding dispersion value σ_{Δ,RN} also is not known. To respect the gap constraint above, although the dispersion value σ_{Δ,RN} is not yet known, the resistance level R_{N} may be determined in accordance with the following formula: R_{N} = Rₘₐₓ - z×σ_{Δ,Rmax}, here with z=zₒ. As the dispersion values σ_{Δ,R} are all the higher than the corresponding resistance R is high, σ_{Δ,Rmax} is greater than σ_{Δ,RN}. The gap Rₘₐₓ - R_{N} thus obtained, which is equal to zₒ×σ_{Δ,Rmax}, is therefore higher than zₒ×σ_{Δ,RN}.

Once the resistance level R_{N} is determined, the corresponding dispersion value σ_{Δ,RN} is deduced therefrom (from the data produced in the step S0).

After step S12, step S11 comprises a step S13, executed from i=N-1 to i=1, by decrementing the integer i by 1 (or i=i-1) at each new execution of the step S13.

At each new execution of the step S13, the target resistance level Rᵢ is determined based on the target resistance level Rᵢ₊₁ that was determined:
- either during the preceding execution of step S13,
- or, for i=N-1, during step S12.

The new target resistance level Rᵢ is determined more precisely in such a way that the gap Rᵢ₊₁ - Rᵢ is equal to zₒ×(σ_{Δ,Ri} + σ_{Δ,Ri+1}), or approximately equal to (and higher than) this quantity.

By thus executing step S13 several times successively, the target resistance levels are therefore determined step by step, from the highest (R_{N}) to the lowest (R₁).

At the beginning of each execution of step S13, the target resistance level Rᵢ to be determined is not yet known, and so, the corresponding dispersion value σ_{Δ,Ri} too is not yet known. To sufficiently separate the target resistance level Rᵢ from the neighbouring resistance level Rᵢ₊₁ (while σ_{Δ,Ri} is not known), one may proceed as follow (figure 6).

First, a first estimation R_{i,est} of the resistance level Rᵢ is determined, as follow: R_{i,est} = Rᵢ₊₁ - (z+1).σ_{Δ,Ri+1}, with, here again, z constant, equal to zₒ. The first estimation R_{i,est} thus obtained is close to the resistance level Rᵢ which will be determined finally, and slightly greater than Rᵢ (see figure 6).

A dispersion value σ_{Δ,Ri,est} is deduced therefrom, associated to this first estimation R_{i,est} (based on the dispersion values σ_{Δ,R} determined in the step S0).

The resistance level Rᵢ is then determined in accordance with the following formula: Rᵢ = Rᵢ₊₁ - z×(σ_{Δ,Ri,est} + σ_{Δ,Ri+1}), with, here again z=zo.

**In** practice, the dispersion value σ_{Δ,Ri,est} estimated in this way is close to the dispersion value σ_{Δ,Ri} corresponding exactly to the target resistance level Rᵢ. In other terms, a gap Rᵢ₊₁ - Rᵢ finally obtained is close to zₒ×(σ_{Δ,Ri} + σ_{Δ,Ri+1}).

Furthermore, as the first estimation R_{i,est}, determined as indicated above, is slightly greater than Rᵢ, the dispersion value σ_{Δ,Ri,est} is also slightly greater than σ_{Δ,Ri}. The gap Rᵢ₊₁ - Rᵢ finally obtained is therefore close to zₒ×[σ_{Δ,Ri} + σ_{Δ,Ri+1}] (which allows for an accurate estimation of the maximum storage capacity of the memory cell), but higher, rather than lower, which is preferable in terms of robustness.

More generally, during the step S11, determining the target resistance levels from the highest to the lowest, rather than the inverse, makes it possible to obtain a gap slightly greater than zₒ×[σ_{Δ,Ri} + σ_{Δ,Ri+1}], for each pair of neighbouring target levels.

**In** step S13, once the resistance level Rᵢ has been determined, the dispersion value σ_{Δ,Ri}, corresponding exactly to the target resistance level Rᵢ finally obtained, may (like here) be determined (σ_{Δ,Ri} then being deduced from Rᵢ, on the basis of dispersion values σ_{Δ,R} determined in step S0), to be subsequently used to determine Rᵢ₋₁. Alternatively, the value σ_{Δ,Ri,est} may be retained as such (for the subsequent determination of Rᵢ₋₁), instead of being replaced by σ_{Δ,Ri}.

Various alternatives can be considered, regarding step S13. For example, the first estimation R_{i,est} of the target resistance level Rᵢ could be determined differently, for example in accordance with the following formula: R_{i,est} = Rᵢ₊₁ - α.z.σ_{Δ,Ri+1}, with α comprised between 1 and 1.5, or in accordance with the formula R_{i,est} = Rᵢ₊₁ - (z+β).σ_{Δ,Ri+1}, with β comprised between 0.5 and 1.5 (which leads both of them to good approximations of σ_{Δ,Ri}).

Besides, the method of determining used in the step S13, which is similar to a perturbative calculation, could comprise additional iterations, in order to further refine the values obtained.

In particular, in order to determine optimally Rᵢ, that is so that Rᵢ₊₁ - Rᵢ = zₒ.(σ_{Δ,Ri+1} + σ_{Δ,Ri}) (while σ_{Δ,Ri} depends on the value of Rᵢ, which is not known prior to its determination), an iterative, bisection method can be used. In this case, several successive estimations R_{i,0}, R_{i,1}, ... R_{i,j} of the target resistance level Rᵢ are determined, to improve gradually the precision with which the equation above is fulfilled.

During the iteration number j, a difference D, equal to:
- the gap Rᵢ₊₁ - R_{i,j} between the target resistance level Rᵢ₊₁ and the ongoing estimation R_{i,j} of the new target resistance level Rᵢ, to be determined, minus
- the quantity zₒ.(σ_{Δ,Ri+1} + σ_{Δ,Ri,j}), where σ_{Δ,Ri,j} is the dispersion value associated with an initialisation interval I centred on this ongoing estimation R_{i,j} of Rᵢ
is calculated.

When the difference D is positive, then, a new estimation R_{i,j+1} of the target resistance level Rᵢ is determined so as to be closer to the target resistance level Rᵢ₊₁ than the previous one, to reduce the gap mentioned above.

On the contrary, when the difference D is negative, which means that the estimation R_{i,j} of Rᵢ is not far enough from Rᵢ₊₁, then, the new estimation R_{i,j+1} of Rᵢ is determined so as to be more distant from Rᵢ₊₁ than before.

These iterations are repeated until the difference D becomes smaller than an acceptable error ε. And Rᵢ is finally equal to the last estimation R_{i,j} determined.

As mentioned above, these iterations are more specifically executed according to a bisection method.

The starting point R_{i,o} of these iterations is calculated as follow: R_{i,o} = Rᵢ₊₁ - 2.zₒ. σ_{Δ,Ri+1}.

As σ_{Δ,R} increases with R, 2×σ_{Δ,Ri+1} is higher than (σ_{Δ,Ri+1} + σ_{Δ,Ri,o}). So, R_{i,o} , determined in this way, is necessarily "too far" from Rᵢ₊₁ (the difference D is positive). R_{i,o} is thus an appropriate starting point for a bisection, iterative determination of Rᵢ. Figure 12 illustrates the relative positions of Rᵢ₊₁ and R_{i,o}, in an example for which N=3 and i=2.

R_{i,1} is then determined as being equal to (R_{i,o} + Rᵢ₊₁)/2. Then, the difference D is computed (for this estimation, R_{i,1}).

If D is positive (meaning that R_{i,1} is still "too far" from Rᵢ₊₁), then R_{i,2} is determined as being equal to (R_{i,1} + Rᵢ₊₁)/2.

But if D is negative (like in the case of figure 13), R_{i,2} is determined as being equal to (Ri,o + R_{i,1})/2.

The difference D is then computed again, for this new estimation, R_{i,2}, and, depending on its sign, another estimation R_{i,3} (more accurate than R_{i,2}) is determined, and so on, until D is small enough.

Similarly, in step S12, the target resistance level R_{N} could be determined using an iterative bisection method, so that R_{N} is finally equal to Rₘₐₓ - zₒ×σ_{Δ,RN}, with a precision ε, instead of determining R_{N}, more roughly, as being equal to Rₘₐₓ- zₒ×σ_{Δ,Rmax} (like is was presented above). Determining the target resistance levels R1, ... Ri, ..., R_{N-1} and/or R_{N} using such a bisection method enables to distribute these levels with an optimal spacing (optimal gap, neither to small, nor overestimated) between them.

Anyhow, step S11 ends once step S13 has been repeated enough times to determine the N target resistance levels R1, ... Ri, ..., R_{N}.

The step S1 then comprises a step of testing, S14, during which it is tested whether or not the quantity R₁ - zₒ×σ_{Δ,1} is greater than or equal to Rₘᵢₙ.

When R₁ - zₒ×σ_{Δ,1} is greater than or equal to Rₘᵢₙ, i.e. when the lowest target resistance level, R₁, is still sufficiently distant from the minimum resistance value Rₘᵢₙ, then, step S1 resumes by executing step S11 again, after having incremented by 1 the value of N (during step S15).

On the contrary, when it is determined that R₁ - zₒ×σ_{Δ,1} is less than Rₘᵢₙ, in step S14, step S1 ends, and the target resistance levels finally adopted are those that were determined during the second last iteration of the step S11.

Figure 7 shows this iterative way of determining the maximum number Nf of target resistance levels that can be placed in the range of resistances [Rₘᵢₙ, Rₘₐₓ]. This example corresponds to a case where the maximum number Nf is equal to 4. In this figure, the target resistance levels determined during step S11, for the different iterations it=1, it=2, it=3, it=4 of this step, are schematically shown. Also shown, schematically (in the form of a bell curve representative of an histogram of values), is the distribution of final resistance values that would be obtained, after relaxing, for initial resistance values distributed respectively in the different initialisation intervals centred on these target resistance levels.

At the end of step S1, the maximum number Nf of target resistance levels that can be placed in the range of resistances [Rₘᵢₙ, Rₘₐₓ] is known.

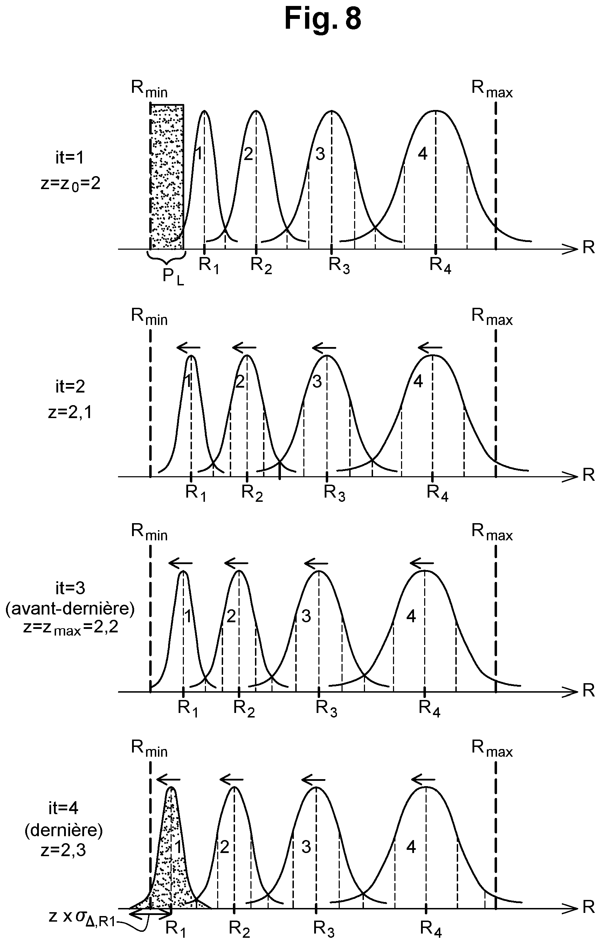

However, the target resistance levels obtained at the end of this step are not always distributed optimally over the range of resistances [Rₘᵢₙ, Rₘₐₓ]. The lowest target resistance level R₁, for example, which is obtained at the end of the step S1, is in general rather separated from the minimum resistance value Rₘᵢₙ, by a quantity greater than the desired minimum gap zₒ×σ_{Δ,R1}. A small portion P_{L} of the range of resistances [Rₘᵢₙ, Rₘₐₓ], located between Rₘᵢₙ and R₁, is therefore unused (see figure 8).

During the following step S2, the distribution of the target resistance levels is optimised, in such a way as to best use the range of resistances [Rₘᵢₙ, Rₘₐₓ], by separating as much as possible these resistance levels from one another, their total number being constant, and equal to the maximum number Nf previously determined.

### Step S2

Step S2 first comprises a step of initialising S20, during which:
- the total number N of target resistance levels to be determined is set to the maximum number Nf (made equal to Nf) and
- the spacing coefficient z is set to an initial value, here equal to zₒ.

Step S11 of determining a set of N target resistance levels R1, ... Ri, ..., R , which was described hereinabove, is then executed.

During step S2, step S11 is repeated, by increasing the spacing coefficient z by a quantity ε at each new execution, until the lowest target resistance level, R₁, becomes too close to the minimum resistance Rₘᵢₙ (see figure 8).

Step S11 is thus iterated, by increasing z by ε at each iteration, while maintaining constant the total number N of levels, until the gap R₁ - Rₘᵢₙ is less than zₒ×σ_{Δ,R1}.

Step S2 is therefore similar to the step S1, but it is carried out by maintaining the total number N fixed and by maximising the spacing coefficient z (instead of maintaining the spacing coefficient fixed and maximising the number of resistance levels).

The quantity ε is positive. It can for example be comprised between 0.02 and 0.5, so as to determine the maximum value zₘₐₓ of the spacing coefficient z with good precision while still obtaining a rapid convergence to this maximum.

After each execution of step S11, the test step S14 described above is executed.

When step S14 shows that the quantity R₁ - zₒ×σ_{Δ,1} is greater than or equal to Rₘᵢₙ (level R₁ sufficiently separated from Rₘᵢₙ), the spacing coefficient z is increased by ε (or z=z+ε), during a step S25, and step S11 is executed again, based on this new value of z.

On the contrary, when step S14 shows that the quantity R₁ - zₒ×σ_{Δ,1} is less than Rₘᵢₙ (level R₁ not sufficiently separated from Rₘᵢₙ), step S2 ends. The target resistance levels finally retained (adopted) at the end of step S2 are those determined during the second last iteration of the step S11 (carried out during step S2). And the optimum, maximum spacing coefficient zₘₐₓ is equal to the spacing coefficient z used during this second last iteration of step S11.

Figure 8 shows the iterative way of distributing the target resistance levels, during step S2, for a maximum number Nf=4. This figure schematically shows the target resistance levels determined during step S11, for different iterations of this step it=1, it=2, it=3 (second last iteration) and it=4 (last iteration). Also shown, schematically (in the form of a bell curve representative of an histogram), is the distribution of the final resistance values that would be obtained, after relaxing, for initial resistance values distributed respectively in the different initialisation intervals centred on these target resistance levels.

As already mentioned, figure 4 shows the target resistance levels obtained by means of the method for determining described above, for an example of a memory cell. In the example of figure 4, the two first initialisation intervals, of width Δ1 and Δ2, are rather narrow and close to one another. Bringing the resistance of the memory cell either in one, or in the other of these two intervals, without a write error, can be constraining in practice (requiring an elaborate electrical control, for example in several steps, during the writing of the memory cell). To overcome these constraints and allow for a more convenient writing of the memory cell, it is then possible to impose that the initialisation intervals have a width Δᵢ at least equal to a minimum threshold, for example a threshold of 2 kiloohms (even having to reduce the total number of target resistance levels).

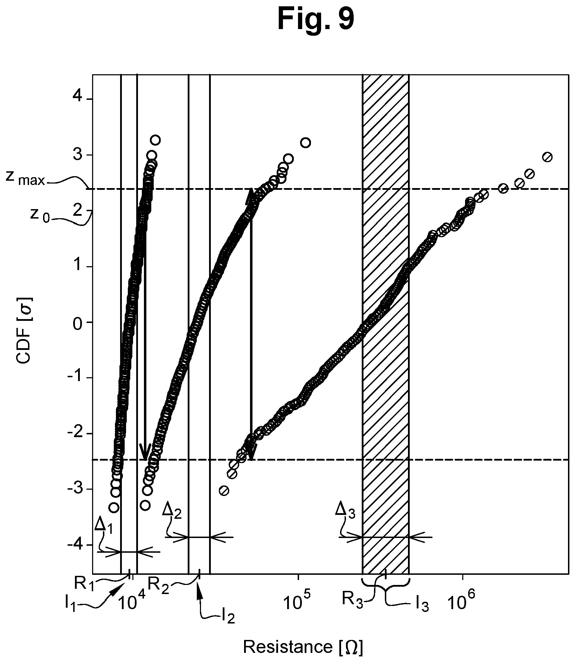

In this case, the method is executed as described above, but by using different width values Δ(R), during step S0 (here, by imposing a minimum width of 2 kiloohms). For the same memory cells as for figure 4, the target resistance levels shown in figure 9 are then obtained. They are then in the number of 3, instead of the number of 4, but are better separated than in the case of figure 4. These three target resistance levels, R₁, R₂, R₃, are shown, as for figure 4, with the initialisation intervals and the corresponding cumulative distribution functions. The three initialisation intervals in question extend respectively from 8 to 11 kiloohms for the first, from 20 to 30 kiloohms for the second, and from 250 to 500 kiloohms for the third.

Figure 10 schematically shows the second embodiment of the method for determining target resistance levels mentioned above. This second embodiment is similar to the first embodiment, but it is executed for a fixed number No of target resistance levels. Thus, in this second embodiment, instead of fixing a minimum spacing coefficient zₒ and deducing therefrom the maximum number Nf of resistance levels complying with this spacing coefficient zo, it is the number No of resistance levels that is fixed, and a maximum spacing coefficient zₘₐₓ complying with this number of resistance levels is deduced therefrom.

This second embodiment mainly comprises a step S2', similar to step S2 of the first embodiment, but during which the spacing coefficient z can either be increased, or decreased, until all of the No target resistance levels are in the range of resistances [Rₘᵢₙ, Rₘₐₓ], with a maximum gap between them.

Step S2' comprises a step of initialising S20' during which:
- the number N of target resistance levels to be determined is set to No, and
- the spacing coefficient z is set to an initial value, for example equal to zₒ.

Step S11, which has been described above, is then executed. At the end of this step, No target resistance levels have been determined.

During the following step S14, it is tested whether the lowest target resistance level, R₁, is greater than the minimum resistance Rₘᵢₙ and separated enough from the latter. More precisely, it is tested whether or not the quantity R₁ - zₒ×σ_{Δ,1} is greater than or equal to Rₘᵢₙ.

When R₁ - zₒ×σ_{Δ,1} is greater than or equal to Rₘᵢₙ, the spacing coefficient z is increased by ε (in step S25'), and the step S11 is executed again, for this increased value of z. This situation corresponds to the right portion of the flow chart of figure 10. Step S11 is then repeated, until the quantity R₁ - zₒ×σ_{Δ,1} becomes less than Rₘᵢₙ Step S2' then ends; the value of z and the target resistance levels finally ADOPTED are then those determined during the second last execution of step S11.

On the contrary, when R₁ - zₒ×σ_{Δ,1} is less than Rₘᵢₙ, the spacing coefficient z is decreased by ε (in step S28'), and step S11 is executed again, for this decreased value of z. This situation corresponds to the left part of the flow chart of figure 10. step S11 is then repeated, until the quantity R₁ - zₒ×σ_{Δ,1} becomes greater than or equal to R_{min s}tep S2' then ends; the value of z and the target resistance levels finally retained are then those determined during the last execution of step S11 (not during the second last execution).

step S2' comprises more precisely, after step S14, a step S26', executed if R1 - zₒ×σ_{Δ,1} is greater than or equal to Rₘᵢₙ. During step S26', it is tested whether the current value of the spacing coefficient z is greater than or equal to the initial value zₒ of the spacing coefficient. If this is the case, the method continues with step S25', then with step S11. Otherwise (z strictly less than zₒ), step S2' ends (and the value of z and the target resistance levels finally retained are then those determined during the last execution of step S11).

Step S2' also comprises, after step S14, a step S27', executed if R₁ - zₒ×σ_{Δ,1} is less than Rₘᵢₙ. During step S27', it is tested if: step S11 was executed just once, before, or if the current value of the spacing coefficient z is strictly less than its initial value zₒ. If one of these two conditions is fulfilled, the method continues with step S28', then S11 (then S14, and so on). On the contrary, if neither of these two conditions is fulfilled, step S2' ends (and the value of z and the target resistance levels finally retained are then those determined during the second last execution of step S11).

When the number No of target resistance levels (which is a fixed input), makes it possible to obtain a spacing coefficient z greater than zₒ (without exceeding the range [Rₘᵢₙ, Rₘₐₓ]), the steps of the method are therefore executed according to the following sequence: S20', then S11, then S14, then S26', then S25' (right loop, corresponding to a progressive increase in z), the loop S11, S14, S26', S25' being executed then again, possibly several times, until R₁ - zₒ×σ_{Δ,1} becomes less than Rₘᵢₙ. Once R₁ - zₒ×σ_{Δ,1} has become less than Rₘᵢₙ, the method continues, after step S14, with step S27', and then ends.

On the contrary, when the number No of target resistance levels does not make it possible to place these No levels in the range [Rₘᵢₙ, Rₘₐₓ], with a spacing coefficient higher than or equal to zₒ, the steps of the method are executed according to the following sequence: S20', then S11, then S14, then S27', then S28' (left loop, corresponding to a progressive decrease in z), the loop S11, S14, S27', S28' being then executed again, possibly several times, until R₁ - zₒ×σ_{Δ,1} becomes greater than or equal to Rₘᵢₙ. Once R₁ - zₒ×σ_{Δ,1} is greater than or equal to Rₘᵢₙ, the method continues, after step S14, with step S26', and then ends.

Different alternatives can be made to the embodiments of the method described above, in addition to those already mentioned. For example, during step S11, instead of determining the target resistance levels from the highest to the lowest, they could be determined from the lowest to the highest (the test step S14 then being carried out by comparing R_{N} to Rₘₐₓ, instead of comparing R1 to Rₘᵢₙ).

Besides, during step S13, instead of determining the new target resistance level Rᵢ based on the neighbouring resistance level Rᵢ₊₁ and dispersion values σ_{Δ,Ri+1} and σ_{Δ,Ri,est}, or σ_{Δ,Ri}, this new target resistance level Rᵢ could be determined based on only the neighbouring resistance level Rᵢ₊₁ and the corresponding dispersion value σ_{Δ,Ri+1}, for example by multiplying this dispersion value by two instead of using the sum (σ_{Δ,Ri+1} + σ_{Δ,Ri,est}). This makes it possible to simplify the determining of the new resistance level Rᵢ. In exchange, the gap Rᵢ₊₁-Rᵢ is slightly oversized.

Moreover, in the first embodiment, step S2 could be omitted.

The scope of protection of the present invention is defined by appended claims 1-14.

## Claims

1. Method for determining target resistance levels (R₁, Rᵢ, Rᵢ₊₁, R_{N}2. for a non-volatile resistive memory cell (4) having an electrical resistance that can be adjusted to different resistance values, the method comprising a step of determining (S13) at least one second target resistance level (Rᵢ), determined on the basis:
- of a first target resistance level (Rᵢ₊₁), and
- of a first resistance dispersion value (σ_{Δ,Ri+1}),
**characterized in that** the non-volatile resistive memory cell is of the filamentary type and the first resistance dispersion value (σ_{Δ,Ri+1}) is representative of the dispersion of a first set of final resistance values obtained, after relaxing of the memory cell, for initial values of the resistance of the memory cell (4) distributed over a first given initialisation interval (Iᵢ₊₁), having a predetermined width (Δᵢ₊₁), said dispersion, after relaxing of the memory cell, being the dispersion of said set of resistance values once the quantity σₙ₊₁/σₙ has reached a stable value, at least in average, σₙ and σₙ₊₁ being the standard deviations at an instant tₙ and at a later instant tₙ₊₁ for these initial values of the resistance of the memory cell.

2. Method according to claim 1, wherein the first initialisation interval (Iᵢ₊₁4. includes the first target resistance level (Rᵢ₊₁).

3. Method according to one of the preceding claims, wherein said width (Δᵢ₊₁) is all the higher than the first target resistance level (Rᵢ₊₁) is high.

4. Method according to one of the preceding claims, wherein the second target resistance level (Rᵢ) is determined, during said step of determining (S13), based furthermore on a second resistance dispersion value (σ_{Δ,Ri}), representative of the dispersion of a second set of final resistance values obtained, after relaxing of the memory cell (4), for initial values of the resistance of the memory cell (4) distributed over a second given initialisation interval (Iᵢ), including the second target resistance level (Rᵢ).

5. Method according to the preceding claim, wherein the second target resistance level (Rᵢ) is determined, during said step of determining (S13), in such a way that a gap between the first target resistance level (Rᵢ₊₁) and the second target resistance level (Rᵢ) is greater than or equal to a sum of the first and second dispersion values (σ_{Δ,Ri+1}, σ_{Δ,Ri}), multiplied by a given spacing coefficient (z).

6. Method according to the preceding claim, wherein the first and second dispersion values (σ_{Δ,Ri+1}, σ_{Δ,Ri}) are the standard deviations, respectively of the first and of the second sets of final resistance values, and wherein the spacing coefficient (z) is greater than or equal to 2.

7. Method according to claim 5 or 6, wherein the second target resistance level (Rᵢ) is determined by successive iterations, during said step of determining (S13), and wherein, during each iteration:
- if the gap between the first target resistance level (Rᵢ₊₁) and the second target resistance level (R_{i,j}) is smaller than the sum of the first and second dispersion values (σ_{Δ,Ri+1}, σ_{Δ,Ri,j}) multiplied by said spacing coefficient (z), the second initialisation interval to which the second dispersion value (σ_{Δ,Ri,j}) corresponds being centred on the value (R_{i,j}) considered for the second target resistance level during said iteration,
- then, at a next iteration, the gap between the first target resistance level (Rᵢ₊₁) and the second target resistance (R_{i,j+1}) is increased,
- said gap being otherwise reduced, at the next iteration.

8. Method according to one of the preceding claims, wherein several target resistance levels (R₁, Rᵢ, Rᵢ₊₁, R_{N}) are determined (S11), wherein, except for one of said resistance levels (R_{N}), that has a maximum (R_{N}) or a minimum value, each one of said target resistance levels (Rᵢ) is determined by executing said step of determining (S13), with the target resistance level (Rᵢ) considered being determined as being equal to said second resistance level, and wherein, each time that the step of determining (S13) is executed again, the first target resistance level (Rᵢ₊₁) is taken as equal to the second target resistance level determined during a previous execution of the step of determining (S13).

9. Method according to claim 8 in the dependency of any of claims 5 to 7, comprising a step of determining a storage capacity (S1) of the memory cell (4), during which a maximum number (Nf) of target resistance levels (R₁, Rᵢ, Rᵢ₊₁, R_{N}) that can be contained within a given range of resistances extending from a minimum resistance value (Rₘᵢₙ) to a maximum resistance value (Rₘₐₓ) is determined, said resistance levels being determined in accordance with claims 5 and 7, or 6 and 7, said spacing coefficient (z) remaining fixed, equal to a given minimum spacing coefficient (zₒₚₜ).

10. Method according to claim 8 in the dependency of any of claims 5 to 7, or according to claim 9, comprising a step of distributing (S2; S2') target resistance levels (R₁, Rᵢ, Rᵢ₊₁, R_{N}), during which:
- the total number (N) of target resistance levels considered remains constant,
- said target resistance levels (R₁, Rᵢ, Rᵢ₊₁, R_{N}) are determined:
∘ in accordance with claims 5 and 7, or 6 and 7,
o in such a way as to remain included within a given range of resistances that extends from a minimum resistance value (Rₘᵢₙ) to a maximum resistance value (Rₘₐₓ),
∘ and in such a way as to maximise said spacing coefficient (z).

11. Method according to claims 9 and 10, wherein, the total number (N) of target resistance levels considered during the step of distributing (S2) is equal to the maximum number (Nf) of target resistance levels (R₁, Rᵢ, Rᵢ₊₁, R_{N}) determined during the step of determining the storage capacity (S1) of the memory cell (4).

12. Method according to one of the preceding claims, further comprising a preliminary step of characterising (S0) the memory cell (4), comprising the following steps:
- (S01) measuring final resistance values after a certain duration of storage (t_{f}), for several different initial resistance values, and
- (S02) determining at least the first dispersion value (σ_{Δ,Ri+1}), from the previously measured final resistance values.

13. Method according to one of the preceding claims, wherein said memory cell (4) is a multiple-level memory cell, suitable for being adjusted, during a write phase, to at least three separate and stable resistance values (R₁, R₂, R₃).

14. Memory device (1) comprising several non-volatile resistive memory cells (4) and an electronic control device (2) for controlling the memory cells (4), the electronic control device (2) being configured to, during the writing of a piece of data in one of said memory cells (4), electrically control said memory cell (4) in such a way as to bring a resistance of the memory cell to a target resistance level belonging to a discrete and predetermined set of target resistance levels (R₁, Rᵢ, Rᵢ₊₁, R_{N}), **characterised in that** the non-volatile resistive memory is of the filamentary type and said target resistance levels (R₁, Rᵢ, Rᵢ₊₁, R_{N}), that the electronic control device (2) is configured to write in the memory cells (4), are separated two by two by a gap that is at least greater than the sum:
- of a first resistance dispersion value (σ_{Δ,Ri+1}), representative of the dispersion of a first set of final resistance values obtained, after relaxing of the memory cell, for initial values of said resistance distributed over a first initialisation interval (Iᵢ₊₁) having a predetermined width (Δᵢ₊₁) and including a first (Rᵢ₊₁) of the two target resistance levels considered (Rᵢ, Rᵢ₊₁), said first resistance dispersion, after relaxing of the memory cell, being the dispersion of said first set of resistance values once the quantity σₙ₊₁/σₙ has reached a stable value, at least in average, σₙ and σₙ₊₁ being the standard deviations at an instant tₙ and at a later instant tₙ₊₁ for these initial values of the resistance of the memory cell, and
- of a second resistance dispersion value (σ_{Δ,Ri}), representative of the dispersion of a second set of final resistance values obtained, after relaxing of the memory cell, for initial values of said resistance distributed over a second initialisation interval (Iᵢ) also having a predetermined width (Δᵢ) and including the second (Rᵢ) of the two target resistance levels considered (Rᵢ, Rᵢ₊₁).

## Patentansprüche

1. Verfahren zum Bestimmen von Zielwiderstandspegeln (R₁, Rᵢ, Rᵢ₊₁ ,R_{N}) für eine nichtflüchtige resistive Speicherzelle (4) mit einem elektrischen Widerstand, der auf verschiedene Widerstandswerte eingestellt werden kann,
wobei das Verfahren einen Schritt des Bestimmens (S13) von mindestens einem zweiten Zielwiderstandspegel (Rᵢ) umfasst, der auf folgender Grundlage bestimmt wird:
- eines ersten Zielwiderstandspegels (Rᵢ₊₁), und
- eines ersten Widerstandsdispersionswerts (σ_{Δ,Ri+1}),
**dadurch gekennzeichnet, dass** die nichtflüchtige resistive Speicherzelle vom Filamenttyp ist und der erste Widerstandsdispersionswert (σ_{Δ4,Ri+1}) repräsentativ für die Dispersion einer ersten Reihe von Endwiderstandswerten ist, die nach Relaxation der Speicherzelle für Anfangswerte des Widerstands der Speicherzelle (4) erhalten werden, die über ein gegebenes erstes Initialisierungsintervall (Lᵢ₊₁ ) verteilt sind, mit einer vorbestimmten Breite (Δᵢ₊₁), wobei die Dispersion nach Relaxation der Speicherzelle die Dispersion der Reihe von Widerstandswerten ist, nachdem die Menge σₙ₊₁) /σₙ zumindest im Durchschnitt einen stabilen Wert erreicht hat, wobei σₙ und σₙ₊₁ die Standardabweichungen zu einem Zeitpunkt tₙ und zu einem späteren Zeitpunkt t_{n±1} für diese Anfangswerte des Widerstands der Speicherzelle sind.

2. Verfahren nach Anspruch 1, bei dem das erste Initialisierungsintervall (Lᵢ₊₁) den ersten Zielwiderstandspegel (Rᵢ₊₁) einschließt.

3. Verfahren nach einem der vorhergehenden Ansprüche, bei dem die Breite (Δᵢ₊₁) umso größer ist, je höher der erste Zielwiderstandspegel (Rᵢ₊₁) ist.

4. Verfahren nach einem der vorhergehenden Ansprüche, bei dem der zweite Zielwiderstandspegel (Rᵢ) in dem Bestimmungsschritt (S13) zusätzlich auf der Grundlage eines zweiten Widerstandsdispersionswerts (σ_{Δ,Ri}) bestimmt wird, repräsentativ für die Dispersion einer zweiten Reihe von Endwiderstandswerten, die nach der Relaxation der Speicherzelle (4) für Anfangswerte des Widerstands der Speicherzelle (4) erhalten werden, die über ein gegebenes zweites Initialisierungsintervall (Iᵢ) verteilt sind, das den zweiten Zielwiderstandspegel (Rᵢ) einschließt.

5. Verfahren nach dem vorhergehenden Anspruch, bei dem der zweite Zielwiderstandspegel (Rᵢ) während des Bestimmungsschritts (S13) so bestimmt wird, dass eine Abweichung zwischen dem ersten Zielwiderstandspegel (Rᵢ₊₁) und dem zweiten Zielwiderstandspegel (Rᵢ) größer oder gleich einer Summe der ersten und zweiten Dispersionswerte (σ_{Δ*,*} Rᵢ₊₁, σ_{Δ*,* Ri}), multipliziert mit einem gegebenen Abstandsfaktor (z), ist.

6. Verfahren nach dem vorhergehenden Anspruch, bei dem der erste und der zweite Dispersionswert (σ_{Δ,Ri+1}, σ_{Δ,Ri}) die Standardabweichungen jeweils der ersten und der zweiten Reihe von Endwiderstandswerten sind, und bei dem der Abstandskoeffizient (z) größer oder gleich 2 ist.

7. Verfahren nach Anspruch 5 oder 6, bei dem der zweite Zielwiderstandspegel (Rᵢ) während des Bestimmungsschritts (S13) in aufeinanderfolgenden Iterationen bestimmt wird, und bei dem während jeder Iteration:
- wenn der Abstand zwischen dem ersten Zielwiderstandspegel (R₁₊ᵢ) und dem zweiten Zielwiderstandspegel (R_{i,j}) kleiner ist als die Summe des ersten und zweiten Dispersionswerts (σ_{Δ,Ri}+1, σ_{Δ,Ri}), multipliziert mit dem Abstandskoeffizienten (z), wobei das zweite Initialisierungsintervall, dem der zweite Dispersionswert (σ_{Δ,Ri,j}) entspricht, auf den Wert (R_{i,j+1}) zentriert ist, der für den zweiten Zielwiderstandspegel während der Iteration berücksichtigt wird,
- dann in einer nächsten Iteration der Abstand zwischen dem ersten Zielwiderstandspegel (Rᵢ₊₁) und dem zweiten Zielwiderstand (R_{i,j+1}) vergrößert wird,
- ansonsten die Abweichung in der nächsten Iteration verringert wird.

8. Verfahren nach einem der vorhergehenden Ansprüche, bei dem mehrere Zielwiderstandspegel (R₁, Rᵢ, Rᵢ₊ᵢ,R_{N}) bestimmt werden (S11), bei dem mit Ausnahme eines der Widerstandspegel (R_{N}), der einen Maximalwert (R_{N}) oder einen Minimalwert hat, jeder der Zielwiderstandspegel (Rᵢ) durch Ausführen des Bestimmungsschritts (S13) bestimmt wird, wobei der berücksichtigte Zielwiderstandspegel (Rᵢ) als gleich dem zweiten Widerstandspegel bestimmt wird, und bei dem jedes Mal, wenn der Bestimmungsschritt (S13) erneut ausgeführt wird, der erste Zielwiderstandspegel (Rᵢ₊ᵢ) als gleich dem zweiten Zielwiderstandspegel genommen wird, der bei einer vorherigen Ausführung des Bestimmungsschritts (S13) bestimmt wurde.

9. Verfahren nach Anspruch 8 nach einem der Ansprüche 5 bis 7, einen Schritt des Bestimmens einer Speicherkapazität (S1) der Speicherzelle (4) umfassend, während dessen eine maximale Anzahl (Nf) von Zielwiderstandspegeln (R₁, Rᵢ, Rᵢ₊₁, R_{N}), die in einem gegebenen Widerstandsbereich von einem minimalen Widerstandswert (Rₘᵢₙ) bis zu einem maximalen Widerstandswert (Rₘₐₓ) enthalten sein können, bestimmt wird, wobei die Widerstandspegel in Übereinstimmung mit den Ansprüchen 5 und 7 oder 6 und 7 bestimmt werden und der Abstandskoeffizient (z) fest bleibt, gleich einem gegebenen minimalen Abstandskoeffizienten (zₒₚₜ).

10. Verfahren nach Anspruch 8 nach einem der Ansprüche 5 bis 7 oder nach Anspruch 9, einen Schritt des Verteilens (S2; S2') von Zielwiderstandspegeln (R₁, Rᵢ, Rᵢ₊₁, R_{N}) umfassend, bei dem:
- die Gesamtzahl (N) der berücksichtigten Zielwiderstandspegel konstant bleibt,
- die Zielwiderstandspegel (R₁, Rᵢ, Rᵢ₊₁, R_{N}) bestimmt werden:
o in Übereinstimmung mit den Ansprüchen 5 und 7 oder 6 und 7,
o so dass sie in einem gegebenen Bereich von Widerständen enthalten bleiben, der von einem minimalen Widerstandswert (Rₘᵢₙ) bis zu einem maximalen Widerstandswert (Rₘₐₓ) reicht,
o und so, dass der Abstandskoeffizient (z) maximiert wird.

11. Verfahren nach den Ansprüchen 9 und 10, bei dem die Gesamtzahl (N) von Zielwiderstandspegeln, die in dem Verteilungsschritt (S2) berücksichtigt werden, gleich der maximalen Anzahl (Nf) von Zielwiderstandspegeln (R₁, Rᵢ, Rᵢ₊₁, R_{N}) ist, die in dem Schritt des Bestimmens der Speicherkapazität (S1) der Speicherzelle (4) bestimmt werden.

12. Verfahren nach einem der vorhergehenden Ansprüche, das außerdem einen einleitenden Schritt zur Charakterisierung (S0) der Speicherzelle (4) umfasst, der die folgenden Schritte umfasst:
- (S01) Messen von Endwiderstandswerten nach einer bestimmten Speicherdauer (tf), für mehrere verschiedene Anfangswiderstandswerte, und
- (S02) Bestimmen mindestens des ersten Dispersionswerts (σ_{Δ,Ri+1}), aus den zuvor gemessenen Endwiderstandswerten.

13. Verfahren nach einem der vorhergehenden Ansprüche, bei dem die Speicherzelle (4) eine Mehrfachpegel-Speicherzelle ist, die während einer Schreibphase auf mindestens drei unterschiedliche und stabile Widerstandswerte (R₁, R₂, R₃) eingestellt werden kann.

14. Speichervorrichtung (1) mit einer Vielzahl von nichtflüchtigen resistiven Speicherzellen (4) und einer elektronischen Steuervorrichtung (2) zum Steuern der Speicherzellen (4),
wobei die elektronische Steuereinrichtung (2) so gestaltet ist, dass sie während des Schreibens von Daten in eine der Speicherzellen (4) die Speicherzelle (4) elektrisch so steuert, dass ein Widerstand der Speicherzelle auf einen Zielwiderstandspegel gebracht wird, der zu einer diskreten und vorbestimmten Reihe von Zielwiderstandspegeln (R₁, Rᵢ, Rᵢ₊₁,R_{N}) gehört,
**dadurch gekennzeichnet, dass** der nichtflüchtige resistive Speicher vom Filamenttyp ist und die Zielwiderstandspegel (R₁, Rᵢ, Rᵢ₊₁, R_{N}), die von der Steuerelektronik (2) in die Speicherzellen (4) geschrieben werden, paarweise durch einen Abstand getrennt sind, der mindestens größer als die Summe ist aus:
- einem ersten Widerstandsdispersionswert (σ_{Δ,} Rᵢ₊₁), der die Dispersion einer ersten Reihe von Endwiderstandswerten darstellt, die nach der Relaxation der Speicherzelle für Anfangswerte des Widerstands erhalten werden, die über ein erstes Initialisierungsintervall (Lᵢ₊₁) verteilt sind, das eine vorbestimmte Breite (Δᵢ₊) hat und ein erstes (Rᵢ₊₁) der beiden berücksichtigten Zielwiderstandspegel (Rᵢ, Rᵢ₊₁) umfasst, wobei die erste Widerstandsdispersion nach Relaxation der Speicherzelle die Dispersion der ersten Reihe von Widerstandswerten ist, sobald die Menge σₙ₊₁ /σₙ zumindest im Durchschnitt einen stabilen Wert erreicht hat, wobei σₙ und σₙ₊ᵢ die Standardabweichungen zu einem Zeitpunkt tₙ und zu einem späteren Zeitpunkt tₙ₊₁ für diese Anfangswerte des Widerstands der Speicherzelle sind, und
- einem zweiten Widerstandsdispersionswert (σ_{Δ, Ri}), der repräsentativ für die Dispersion einer zweiten Reihe von Endwiderstandswerten ist, die nach der Relaxation der Speicherzelle für Anfangswerte des Widerstands erhalten wurden, die über ein zweites Initialisierungsintervall (Iᵢ) verteilt sind, das ebenfalls eine vorbestimmte Breite (Δᵢ) aufweist und den zweiten (Rᵢ) der beiden berücksichtigten Zielwiderstandspegel (Rᵢ, Rᵢ₊₁) einschließt.

## Revendications

1. Procédé de détermination de niveaux de résistance cibles (R₁, Rᵢ, Rᵢ₊₁, R_{N}) pour une cellule mémoire résistive non volatile (4) ayant une résistance électrique qui peut être ajustée à différentes valeurs de résistance,
le procédé comprenant une étape de détermination (S13) d'au moins un deuxième niveau de résistance cible (Rᵢ), déterminé sur la base :
- d'un premier niveau de résistance cible (Rᵢ₊₁), et
- d'une première valeur de dispersion de résistance (σ_{Δ,Ri+1}),
**caractérisé en ce que** la cellule mémoire résistive non volatile est du type filamentaire et la première valeur de dispersion de résistance (σ_{Δ,Ri+1}) est représentative de la dispersion d'un premier ensemble de valeurs de résistance finale obtenues, après relaxation de la cellule mémoire, pour des valeurs initiales de la résistance de la cellule mémoire (4) réparties sur un premier intervalle d'initialisation donné (Lᵢ₊₁), ayant une largeur prédéterminée (Δᵢ₊₁), ladite dispersion, après relaxation de la cellule mémoire, étant la dispersion dudit ensemble de valeurs de résistance une fois que la quantité σₙ₊₁/σₙ a atteint une valeur stable, au moins en moyenne, σₙ et σₙ₊₁ étant les écarts-types à un instant tₙ et à un instant ultérieur t_{n±1} pour ces valeurs initiales de la résistance de la cellule mémoire.

2. Procédé selon la revendication 1, dans lequel le premier intervalle d'initialisation (Lᵢ₊₁) inclut le premier niveau de résistance cible (Rᵢ₊₁).

3. Procédé selon l'une des revendications précédentes, dans lequel ladite largeur (Δᵢ₊₁) est d'autant plus grande que le premier niveau de résistance cible (Rᵢ₊₁) est élevé.

4. Procédé selon l'une des revendications précédentes, dans lequel le deuxième niveau de résistance cible (Rᵢ) est déterminé, lors de ladite étape de détermination (S13), en se basant en outre sur une deuxième valeur de dispersion de résistance (σ_{Δ,Ri}), représentative de la dispersion d'un deuxième ensemble de valeurs de résistance finales obtenues, après relaxation de la cellule mémoire (4), pour des valeurs initiales de la résistance de la cellule mémoire (4) réparties sur un deuxième intervalle d'initialisation donné (Iᵢ), incluant le deuxième niveau de résistance cible (Ri).

5. Procédé selon la revendication précédente, dans lequel le deuxième niveau de résistance cible (Rᵢ) est déterminé, pendant ladite étape de détermination (S13), de telle manière qu'un écart entre le premier niveau de résistance cible (Rᵢ₊₁) et le deuxième niveau de résistance cible (Rᵢ) soit supérieur ou égal à une somme des première et deuxième valeurs de dispersion (σ_{Δ,Ri+1}, σ_{Δ,Ri}) multipliées par un coefficient d'espacement donné (z).

6. Procédé selon la revendication précédente, dans lequel les première et deuxième valeurs de dispersion (σ_{Δ,Ri+1}, σ_{Δ,Ri}) sont les écarts-types, respectivement, des premier et deuxième ensembles de valeurs de résistance finale, et dans lequel le coefficient d'espacement (z) est supérieur ou égal à 2.

7. Procédé selon la revendication 5 ou 6, dans lequel le deuxième niveau de résistance cible (Rᵢ) est déterminé par itérations successives, pendant ladite étape de détermination (S13), et dans lequel, pendant chaque itération :
- si l'écart entre le premier niveau de résistance cible (R₁₊ᵢ) et le deuxième niveau de résistance cible (R_{i,j}) est plus petite que la somme des première et deuxième valeurs de dispersion (σ_{Δ,Ri}+1, σ_{Δ,Ri}) multipliée par ledit coefficient d'espacement (z), le deuxième intervalle d'initialisation auquel correspond la deuxième valeur de dispersion (σ_{Δ,Ri,j}) étant centré sur la valeur (R_{i,j+1}) considérée pour le deuxième niveau de résistance cible pendant ladite itération,
- ensuite, lors d'une itération suivante, l'écart entre le premier niveau de résistance cible (Rᵢ₊₁) et la deuxième résistance cible (R_{i,j+1}) est augmenté,
- ledit écart étant sinon réduit, à l'itération suivante.

8. Procédé selon l'une des revendications précédentes, dans lequel plusieurs niveaux de résistance cibles (R₁, Rᵢ, Rᵢ₊ᵢ, R_{N}) sont déterminés (S11), dans lequel, à l'exception de l'un desdits niveaux de résistance (R_{N}), qui a une valeur maximale (R_{N}) ou une valeur minimale, chacun desdits niveaux de résistance cibles (Rᵢ) est déterminé en exécutant ladite étape de détermination (S13), le niveau de résistance cible (Rᵢ) considéré étant déterminé comme étant égal audit deuxième niveau de résistance, et dans lequel, chaque fois que l'étape de détermination (S13) est exécutée à nouveau, le premier niveau de résistance cible (Rᵢ₊ᵢ) est pris comme étant égal au deuxième niveau de résistance cible déterminé lors d'une exécution précédente de l'étape de détermination (S13).

9. Procédé selon la revendication 8 en dépendance de l'une quelconque des revendications 5 à 7, comprenant une étape de détermination d'une capacité de stockage (S1) de la cellule mémoire (4), pendant laquelle un nombre maximal (Nf) de niveaux de résistance cibles (R₁, Rᵢ, Rᵢ₊₁, R_{N}) qui peuvent être contenus dans une plage donnée de résistances allant d'une valeur de résistance minimale (Rₘᵢₙ) à une valeur de résistance maximale (Rₘₐₓ) est déterminé, lesdits niveaux de résistance étant déterminés en conformité avec les revendications 5 et 7, ou 6 et 7, ledit coefficient d'espacement (z) restant fixe, égal à un coefficient d'espacement minimal donné (zₒₚₜ).

10. Procédé selon la revendication 8 en dépendance de l'une quelconque des revendications 5 à 7, ou selon la revendication 9, comprenant une étape de répartition (S2 ; S2') de niveaux de résistance cibles (R₁, Rᵢ, Rᵢ₊₁, R_{N}), au cours de laquelle :
- le nombre total (N) de niveaux de résistance cibles considérés reste constant,
- lesdits niveaux de résistance cibles (R₁, Rᵢ, Rᵢ₊₁, R_{N}) sont déterminés :
o en conformité avec les revendications 5 et 7, ou 6 et 7,
o de manière à rester inclus dans une plage donnée de résistances qui va d'une valeur de résistance minimale (Rₘᵢₙ) à une valeur de résistance maximale (Rₘₐₓ),
o et de manière à maximiser ledit coefficient d'espacement (z).

11. Procédé selon les revendications 9 et 10, dans lequel le nombre total (N) de niveaux de résistance cibles considérés lors de l'étape de répartition (S2) est égal au nombre maximal (Nf) de niveaux de résistance cibles (R₁, Rᵢ, Rᵢ₊₁, R_{N}) déterminés lors de l'étape de détermination de la capacité de stockage (S1) de la cellule mémoire (4).

12. Procédé selon l'une des revendications précédentes, comprenant en outre une étape préliminaire de caractérisation (S0) de la cellule mémoire (4), comprenant les étapes suivantes :
- (S01) mesure de valeurs de résistance finale après une certaine durée de stockage (tf), pour plusieurs valeurs de résistance initiale différentes, et
- (S02) détermination d'au moins la première valeur de dispersion (σ_{Δ,Ri+1}), à partir des valeurs de résistance finales précédemment mesurées.

13. Procédé selon l'une des revendications précédentes, dans lequel ladite cellule mémoire (4) est une cellule mémoire multi-niveaux, apte à être ajustée, pendant une phase d'écriture, à au moins trois valeurs de résistance (R₁, R₂, R₃) distinctes et stables.

14. Dispositif mémoire (1) comprenant plusieurs cellules mémoire résistives non volatiles (4) et un dispositif de commande électronique (2) permettant de commander les cellules mémoire (4),
le dispositif de commande électronique (2) étant configuré pour, pendant l'écriture d'une donnée dans l'une desdites cellules mémoire (4), commander électriquement ladite cellule mémoire (4) de manière à amener une résistance de la cellule mémoire à un niveau de résistance cible appartenant à un ensemble discret et prédéterminé de niveaux de résistance cibles (R₁, Rᵢ, Rᵢ₊₁, R_{N}),
**caractérisée en ce que** la mémoire résistive non volatile est du type filamentaire, et lesdits niveaux de résistance cible (R₁, Rᵢ, Rᵢ₊₁, R_{N}), que le dispositif électronique de commande (2) est configuré pour écrire dans les cellules mémoire (4), sont séparés deux à deux par un écart qui est au moins supérieur à la somme :
- d'une première valeur de dispersion de résistance (σ_{Δ,Ri+1}), représentative de la dispersion d'un premier ensemble de valeurs de résistance finale obtenues, après relaxation de la cellule mémoire, pour des valeurs initiales de ladite résistance réparties sur un premier intervalle d'initialisation (Lᵢ₊₁) ayant une largeur prédéterminée (Δᵢ₊₁) et incluant un premier (Rᵢ₊₁) des deux niveaux de résistance cible considérés (Rᵢ, Rᵢ₊₁), ladite première dispersion de résistance, après relaxation de la cellule mémoire, étant la dispersion dudit premier ensemble de valeurs de résistance une fois que la quantité σₙ₊₁/σₙ a atteint une valeur stable, au moins en moyenne, σₙ et σₙ₊ᵢ étant les écarts-types à un instant tₙ et à un instant ultérieur tₙ₊₁ pour ces valeurs initiales de la résistance de la cellule mémoire, et
- d'une deuxième valeur de dispersion de résistance (σ_{Δ,Ri}), représentative de la dispersion d'un deuxième ensemble de valeurs de résistance finales obtenues, après relaxation de la cellule mémoire, pour des valeurs initiales de ladite résistance réparties sur un deuxième intervalle d'initialisation (Iᵢ) ayant également une largeur prédéterminée (Δᵢ) et incluant le deuxième (Rᵢ) des deux niveaux de résistance cibles considérés (Rᵢ, Rᵢ₊₁).
